# EUROPEAN PATENT APPLICATION

(11) **EP 4 722 744 A1**
(43) Date of publication of application: **08.04.2026**
(21) Application number: 24839732.5
(22) Date of filing: 08.07.2024
(51) Int. Cl.: G01R 31/26, G01R 1/073, H01B 1/00, H01B 1/22, H01B 5/00, H01B 5/16, H01L 21/66, H01R 11/01

(54) **ANISOTROPIC ELECTROCONDUCTIVE FILM, ELECTROCONDUCTIVE CONNECTOR, AND ELECTROCONDUCTIVE STRUCTURE USED THEREFOR**

(30) Priority: 07.07.2023 JP 2023112113
(71) Applicant: Kimura, Kiyoshi, Hanno-shi, Saitama 357-0041 (JP)
(72) Inventor: MIYAMURA Masataka, Kamakura-shi, Kanagawa 248-0025 (JP); BONKOHARA Manabu, Kamagaya-shi, Chiba 273-0112 (JP); KIMURA Kiyoshi, Hanno-shi, Saitama 357-0041 (JP)
(74) Representative: Prüfer & Partner mbB Patentanwälte · Rechtsanwälte
(86) International application number: PCT/JP2024/024673
(87) International publication number: WO 2025/013842

(57) **Abstract**

An anisotropic electroconductive film and an electroconductive connector that make it possible to achieve lower resistance than the prior art, improved highfrequency characteristics and higher resolution, improved contact stability due to reduced contact pressure, increased electrical current capacity, and improved durability are provided.

An anisotropic electroconductive film 110 includes an electrically insulative thin film 112 made of an elastic polymer material, and particles 200 made of a substance exhibiting topological antiferromagnetic properties, which are dispersed in the electrically insulative thin film 112 and which are given magnetic anisotropy so that an easy direction of magnetization is in a thickness direction of the electrically insulative thin film 112. The particles 200 form conduction portions 114 which are arranged at intervals in an in-plane direction of the electrically insulative thin film 100 for enabling electrical conduction along the thickness direction thereof. Each conduction portion 114 is formed by the single particle 200 (or the particles 200 aligned in the thickness direction). Each particle 200 has a south pole region 604 and a north pole region 602 formed respectively at two ends thereof along the easy direction of magnetization, and the south pole region and the north pole region are subject to concentration of magnetic flux of virtual magnetic fields.

## Description

### TECHNICAL FIELD

The present invention relates to an anisotropic electroconductive film, an electroconductive connector, and an electroconductive structure used therefor and more particularly, to an anisotropic electroconductive film that has a structure where conduction portions made of a substance exhibiting topological antiferromagnetic properties are disposed in an electrically insulative thin film made of an electrically insulative polymer material and that exhibits an anisotropic electroconductivity in the thickness direction thereof; an electroconductive connector having a structure where movable electrodes are combined with the anisotropic electroconductive film; and an electroconductive structure that is suitably used for conduction portions disposed in the anisotropic electroconductive film and the electroconductive connector.

### BACKGROUND ART

In the manufacturing process of integrated circuits (hereinafter referred to as ICs), after forming desired circuits on a silicon wafer (hereinafter simply referred to as a wafer also), wafer tests are performed to verify whether the circuits function properly. These wafer tests are performed using a semiconductor testing apparatus. Specifically, the semiconductor testing apparatus inspects the electrical characteristics of the circuits by contacting a probe, which is mounted on a test head, with the wafer and transmitting and receiving electrical signals between the semiconductor testing apparatus to which the test head is electrically connected and the circuits formed on the wafer.

Typically, hundreds of ICs are formed on a silicon wafer, and wafer tests are performed collectively or separately in the state where these ICs are not separated. If the ICs are memories such as RAMs or ROMs, the number of electrodes per IC is in the tens to hundreds, but if the ICs are CPUs, GPUs, MPUs, etc., the number of electrodes per IC can be in the hundreds to tens of thousands. Therefore, when testing a plurality of ICs simultaneously, it is necessary to electrically connect the probe to tens of thousands or more of electrodes at once.

In recent years, in addition to metal probes, probes using anisotropic electroconductive films (so-called electroconductive rubber) have also come into use as probes for semiconductor testing apparatuses. This is because probes using anisotropic electroconductive films are less susceptible to damage due to deformation of the test electrodes than metal probes, and are also advantageous for miniaturizing the test electrode spacing. However, because the fragility of anisotropic electroconductive films has become an issue with miniaturization, their use has been limited to package probes designed for testing ICs after separation and packaging. In other words, practical application of anisotropic electroconductive films in wafer probes designed for testing ICs before separation has not yet been realized.

Prior to this application, the applicant developed an anisotropic electroconductive film and filed a patent application, which has already been granted a patent (see Patent Literature 1). The anisotropic electroconductive film disclosed in Patent Literature 1 (Japanese Patent Publication No. 5755527) is a sheet-like anisotropic electroconductive film having anisotropic electrical conductivity in the thickness direction, in which electroconductive particles are dispersed in an elastic electrically insulative polymer material. This anisotropic electroconductive film has such a structure that the particle size d10 of the electroconductive particles at the cumulative 10% of the cumulative particle size distribution is equal to or less than half the particle size d90 thereof at the cumulative 90% of the cumulative particle size distribution, and that the particle size d90 of the electroconductive particles is in the range from 70% to 90% of the average thickness of the elastic electrically insulative polymer material. The limitation that the particle size d90 of the electroconductive particles is in the range from 70% to 90% of the average thickness of the elastic electrically insulative polymeric material, i.e., approximately 80%, in the cumulative particle size distribution has the following meaning:

Specifically, this means that when the test head is pressed against the wafer, the electrodes on the electrode substrate of the test head which is placed on one side of the anisotropic electroconductive film and the terminals (electrodes) of the circuits on the wafer which is placed on the other side of the anisotropic electroconductive film are electrically connected to each other via the individual (single) electroconductive particles of the particle size d90 (large diameter), and that the individual (single) electroconductive particles of the particle size d90 (large diameter) function as spacers.

Furthermore, since several of the electroconductive particles of the particle size d10 (small diameter) are arranged in a chain shape in the thickness direction of the anisotropic electroconductive film to form a conduction path, the anisotropic electroconductivity in the thickness direction of the anisotropic electroconductive film is ensured not only by the conduction paths formed by the electroconductive particles of the particle size d90 (large diameter), but also by the conduction paths formed by the electroconductive particles of the particle shape d10 (small diameter).

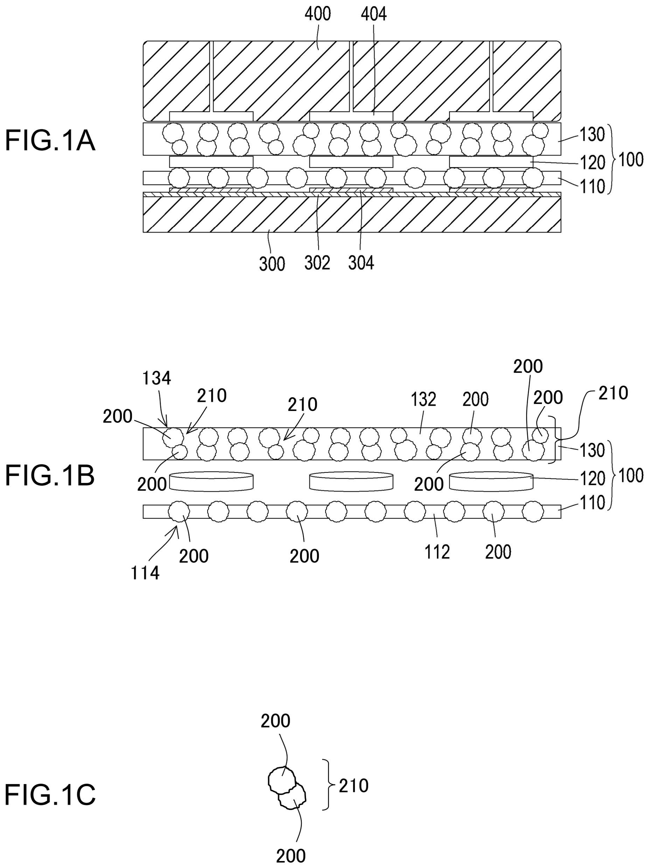

Therefore, in the anisotropic electroconductive film of Patent Literature 1, while ensuring the anisotropic electroconductivity in the thickness direction of the anisotropic conductive film by the aforementioned conduction paths formed by the individual (single) electroconductive particles of the particle size d90 (large diameter) and the aforementioned conduction paths formed by the electroconductive particles of the particle size d10 (small diameter), excessive deformation of the anisotropic electroconductive film can be prevented by the aforementioned spacers (see Claim 1, Paragraphs 0009 to 0043, and Figures 1 to 4).

Patent Literature 2 (Japanese Patent Publication No. 5476221) discloses an anisotropic electroconductive film having such a structure that electroconductive particles, each of which is formed by coating the surface of a base material particle with a nickel-containing nickel electroconductive layer, are dispersed in an electrically insulative binder resin. The nickel electroconductive layer is preferably a nickel alloy layer, more preferably a nickel alloy plated layer. The outer surface of the nickel electroconductive layer is covered with a coating containing nickel oxide or nickel hydroxide. When the aforementioned test head is pressed against the aforementioned wafer, the coating containing nickel oxide or nickel hydroxide that coats the outer surface of the nickel electroconductive layer is destroyed. Therefore, when the anisotropic electroconductive film is used, the coating is destroyed and as a result, electrical conduction between the electrodes of the test head and the terminals (electrodes) on the wafer via the nickel electroconductive layer can be accomplished while preventing the nickel electroconductive layer from being modified due to corrosive gases existing in the atmosphere by the coating (see Claim 5, Paragraphs 0024 to 0084, and Figures 1 to 3).

Patent Literature 3 (Japanese Patent Application Publication No 2021-064591) discloses an anisotropic electroconductive film having such a structure that coated particles, each of which is a particle having an electroconductive surface that is coated with an electrically insulative layer, are dispersed in an electrically insulative resin. The electrically insulative layer includes a non-electroconductive first material and a non-electroconductive second material, and the first material and the second material have opposite polarities of zeta potential measured at 25°C and pH 7. The electroconductive particle is, for example, configured by covering at least a part of the surface of a core material made of a non-electroconductive or electroconductive material with an electroconductive coating made of an electroconductive material. The aforementioned condition related to the polarity of the zeta ionization is intended to increase adhesion between the first material and the second material to form a dense electrically insulative layer and to prevent peeling of the electrically insulative layer from the electroconductive particle, which makes it possible to improve the insulation reliability of the coated particles. When the aforementioned test head is pressed against the aforementioned wafer, the electrically insulative layer covering the surface of the electroconductive particles is destroyed, thereby making it possible to establish electrical conduction between the electrodes of the test head and the terminals (electrodes) on the wafer via the surfaces of the electroconductive particles (see Summary, Claim 14, Paragraphs 0016 to 0154, and Figures 1 to 2).

Patent Literature 4 (Japanese Patent Application Publication No 2022-041178) discloses a coated particle formed by an electroconductive particle made of a core material whose surface is covered with a metal coating, and an electrically insulative layer formed on the metal coating. The electrically insulative layer contains a block copolymer having a hydrophobic portion and a hydrophilic portion, and an inorganic compound is supported in the hydrophilic portion of the block copolymer. The inorganic compound supported on the electrically insulative layer successfully penetrates the electrode, making it easier for the electroconductive particle to be fixed to the electrode. For this reason, electrical conductivity with the electrode can be improved while allowing the coated particle to exhibit appropriate elasticity during the electrical connection in the formation of electronic circuits. In the coated particle also, electrical conductivity between the electrodes of the aforementioned test head and the terminals (electrodes) on the aforementioned wafer is accomplished by destroying the electrically insulative layer covering the electroconductive particle, which is similar to Patent Literatures 2 and 3 (see Abstract, Paragraphs 0014 to 0119, and Figures 1 to 7).

### PRIOR ART LITERATURE

### PATENT LITERATURE

Patent Literature 1: Japanese Patent Publication No. 5755527
Patent Literature 2: Japanese Patent Publication No. 5476221
Patent Literature 3: Japanese Patent Application Publication No. 2021-064591
Patent Literature 4: Japanese Patent Application Publication No. 2022-041178

### SUMMARY OF THE INVENTION

### PROBLEMS TO BE RESOLVED BY THE INVENTION

In the anisotropic electroconductive film of Patent Literature 1, when the electrodes on the test head which is placed on one side of the anisotropic electroconductive film are pressed against the circuit terminals (electrodes) on the wafer which is placed on the other side of the anisotropic electroconductive film, the individual (single) electroconductive particles of the particle size d90 (large diameter) function as spacers. Therefore, excessive pressure is not applied to the anisotropic electroconductive film, which makes it possible to suppress excessive deformation of the anisotropic electroconductive film. Accordingly, the durability of the anisotropic electroconductive film can be effectively improved and as a result, improved electrical characteristics can be ensured. However, ICs are likely to become further miniaturized and more highly integrated, and the number of contacts is increasing. For this reason, existing anisotropic electroconductive films, including the said anisotropic electroconductive film, are required to further improve high-frequency characteristics due to further reduction of electrical resistance and to achieve higher resolution to accommodate finer pitches. Moreover, to achieve these requirements, it is also necessary to improve contact stability with the electrodes (terminals) of ICs, to increase electrical current capacity according to miniaturization and high integration of ICs, and to improve durability.

On the other hand, the anisotropic electroconductive film of Patent Literature 2 is configured to obtain electrical conduction through the nickel electroconductive layer by applying a high load to destroy the coating containing nickel oxide or nickel hydroxide that covers the outer surface of the nickel electroconductive layer. Similarly, the anisotropic electroconductive film of Patent Literature 3 is configured to obtain electrical conduction through the surface of the electroconductive particle by applying a high load to destroy the electrically insulative layer that covers the surface of the electroconductive particle. The coated particle of Patent Literature 4 is also configured to obtain electrical conduction by applying a high load to destroy the electrically insulative layer that covers the electroconductive particle, which is similar to Patent Literatures 2 and 3.

For this reason, all of the anisotropic electroconductive films of Patent Literatures 2 and 3 and the coated particle of Patent Literature 4 have a disadvantage that the contact resistance is increased and the contact state is unstable when the electrodes of the test head are pressed against the terminals (electrodes) on the wafer. This means that even if these anisotropic electroconductive films or the coated particle is/are used, it is not possible to meet the above-mentioned demands, such as improvement of the contact stability with the electrodes (terminals) of ICs, increase in electrical current capacity according to miniaturization and high integration of ICs, and improvement of the durability.

The present invention has been created in consideration of the above-mentioned circumstances and its object is to provide an anisotropic electroconductive film that makes it possible to realize improvement of high-frequency characteristics and achievement of higher resolution by reducing the contact resistance (electrical resistance) when the electrodes of a test head are pressed against the terminals (electrodes) on a wafer compared with the prior art, and that makes it possible to realize improvement and retainment of contact stability, increase in electrical current capacity (increase in allowable electrical current), and improvement of durability by reducing the contact pressure (contact force) when the electrodes of a test head are pressed against the terminals (electrodes) on a wafer compared with the prior art; an electroconductive connector using the anisotropic electroconductive film; and an electroconductive structure that is suitably used for the anisotropic electroconductive film and the electroconductive connector.

Other objects of the present invention not specified here will be clarified from the following description and attached drawings.

### MEANS FOR SOLVING THE PROBLEMS

(1) An anisotropic electroconductive film according to the present invention comprises:
   an electrically insulative thin film made of an elastic electrically insulative polymer material; and
   approximately spherical particles, which are made of a substance exhibiting topological antiferromagnetic properties, dispersed in the electrically insulative thin film;
   wherein the particles form conduction portions that are arranged apart from each other in an in-plane direction of the electrically insulative thin film so as not to generate electrical conduction in the in-plane direction and that allow electrical conduction in a thickness direction of the electrically insulative thin film;
   each of the particles has magnetic anisotropy, and its easy direction of magnetization is oriented in the thickness direction of the electrically insulative thin film;
   each of the particles has a south pole region and a north pole region that are respectively formed at two ends thereof in a direction along the easy direction of magnetization, each of the south pole region and the north pole region being subject to concentration of magnetic flux of virtual magnetic fields; and
   each of the particles has spin current path candidates (magnetic circuits) that connect the south pole region and the north pole region;
   and wherein a voltage is applied between the south pole region and the north pole region along the easy direction of magnetization during operation, which causes
      (a) an inside of each of the particles to enter a superconducting state;
      (b) a spin current to flow through one of the spin current path candidates (magnetic circuits) in a site existing between the south pole region and the north pole region;
      (c) an electrical current to flow in a site from an outside to the south pole region of the particle and a site from the outside to the north pole region of the particle; and
      (d) electrical current-spin current conversion to occur in the south pole region and the north pole region;
   thereby achieving electrical conduction in the thickness direction of the electrically insulative thin film through the conduction portions.

As described above, the anisotropic electroconductive film according to the present invention comprises the conduction portions that allow electrical conduction in the thickness direction of the electrically insulative thin film, which are formed by the particles dispersed in the electrically insulative thin film, wherein the conduction portions are arranged apart from each other in the electrically insulative thin film in its in-plane direction so as not to generate electrical conduction in its in-plane direction. Therefore, electrical conduction is imparted only in the thickness direction of the electrically insulative thin film. This means that the anisotropic electroconductive film according to the present invention has anisotropic electrical conductivity.

Moreover, each of the particles is approximately spherical and has magnetic anisotropy. The easy direction of magnetization of each of the particles is oriented in the thickness direction of the electrically insulative thin film. Each of the particles has the south pole region and the north pole region which are respectively formed at the two ends along the easy direction of magnetization. Each of the south pole region and the north pole region is subject to concentration of the magnetic flux of the virtual magnetic fields. Therefore, when a voltage is applied between the south pole region and the north pole region along the easy direction of magnetization during operation,
(a) the inside of each of the particles enters a superconducting state,
(b) a spin current flows in a site existing between the south pole region and the north pole region,
(c) an electrical current flows in a site from the outside to the south pole region of the particle and a site from the outside to the north pole region of the particle, and
(d) electrical current-spin current conversion occurs in the south pole region and the north pole region.

As a result of the above (a) to (d), electrical conduction in the thickness direction of the electrically insulative thin film through the conduction portions is realized with extremely low resistance.

In the anisotropic electroconductive film according to the present invention, since electrical conduction through the conduction portions in the thickness direction of the electrically insulative thin film is realized in the manner as described above, the electrical resistance of the said anisotropic electroconductive film is extremely low. For example, the electrical resistance is reduced to an extremely low level which is similar to that when superconductivity occurs.

Moreover, since such the extremely low electrical resistance as described above is achieved, the high-frequency characteristics of the said anisotropic electroconductive film are improved and the electrical current capacity thereof also can be increased.

Furthermore, since the conduction portions, which are formed by the substance that exhibits topological antiferromagnetic properties, have magnetic anisotropy whose easy direction of magnetization is oriented in the thickness direction of the electrically insulative thin film, it is possible to make the arrangement pitch of the conduction portions as minute as the diameters of the particles. Therefore, it is possible to realize higher resolution than the prior art. This means that it is also possible to accommodate finer pitches that will be required due to the further miniaturization and higher integration of ICs in the future.

Furthermore, it is conjectured that spin currents that flow in the conduction portions pass through the potential barrier to result in electrical conduction due to the quantum-mechanical tunneling effect without destroying an electrically insulative film such as an oxide film existing on the surface of a contact object such as an electrode or terminal. Therefore, by simply pressing the contact object against the electrically insulative thin film with an extremely low pressure, in other words, by using an extremely small contact pressure, electrical conduction between the contact object and the conduction portions is accomplished. Accordingly, the contact stability is improved compared with the prior art.

Furthermore, as described above, the contact object and the conduction portions are electrically connected with each other by simply pressing the contact object against the electrically insulative thin film with an extremely low pressure or an extremely low contact pressure and therefore, the amount of displacement of the electrically insulative thin film can be greatly reduced. Accordingly, the durability of the anisotropic electroconductive film is improved.

(2) In a preferred embodiment of the anisotropic electroconductive film according to the present invention, each of the conduction portions is formed by one of the particles;
wherein a diameter of the particle is set to be larger than a thickness of the electrically insulative thin film so that ends of the particle protrude respectively from both sides of the electrically insulative thin film in a state where the electrically insulative thin film is not deformed by pressure.

In this embodiment, by adjusting the strength of a magnetic field applied to the particles in order to impart magnetic anisotropy thereto, it is possible to set the level of magnetic anisotropy possessed by the single particle that forms each of the conduction portions to a high level (e.g., the maximum level) at which the magnetic anisotropy is not disturbed. For this reason, there is an advantage that the resistance of a spin current that flows through the conduction portion can be reduced to an extremely low level.

(3) In another preferred embodiment of the anisotropic electroconductive film according to the present invention, each of the conduction portions is formed by a cluster made of the particles that are arranged in the thickness direction of the electrically insulative thin film;
wherein a length of the cluster in the thickness direction of the electrically insulative thin film is set to be larger than a thickness of the electrically insulative thin film so that ends of the particles are respectively exposed to both sides of the electrically insulative thin film in a state where the electrically insulative thin film is not deformed by pressure.

In this embodiment, by minimizing the number of the particles arranged in the in-plane direction of the electrically insulative thin film in the cluster and adjusting the strength of a magnetic field applied to the particles in order to impart magnetic anisotropy thereto, it is possible to set the level of magnetic anisotropy possessed by the single cluster that forms each of the conduction portions to a high level (e.g., a level slightly lower than the maximum level) at which the disturbance of the magnetic anisotropy is minimized. For this reason, there is an advantage that the resistance of a spin current that flows through the conduction portion can be reduced to an extremely low level.

(4) In still another preferred embodiment of the anisotropic electroconductive film according to the present invention, the electrically insulative thin film is in a form of a sheet that is barely stretched or shrunk in the in-plane direction of the electrically insulative thin film and that is flexible (deformable) in the thickness direction of the electrically insulative thin film.

In this embodiment, when the electrically insulative thin film is brought into contact with a contact object such as an electrode or terminal, the electrically insulative thin film is easily deformed elastically in the thickness direction of the electrically insulative thin film in accordance with irregularities existing on the surface of the contact object, thereby making it possible to absorb the irregularities. On the other hand, since the electrically insulative thin film is barely stretched or shrunk in the in-plane direction of the electrically insulative thin film upon contact with the contact object, there is an advantage that the risk of problems such as poor conductivity occurring due to shifts of the arrangement positions of the conduction portions is eliminated.

(5) In a further preferred embodiment of the anisotropic electroconductive film according to the present invention, the electrically insulative substance exhibiting topological antiferromagnetic properties that forms the particles is NiO (nickel oxide) or MnO (manganese oxide). In this case, it is preferred that metallic Ni or metallic Mn refined by the carbonyl method is used as a source material from which NiO or MnO is derived. This is because according to the inventors' research, to the extent currently known, the most favorable results were obtained in terms of both exhibition of the electrical current-spin current conversion and exhibition of the functions of a type-II superconductor when metallic Ni or metallic Mn refined by the carbonyl method was used.

In addition to NiO and MnO, other usable materials include Cr₂O₃, Mn₃Ge, Mn₃Sn, MnS, MnTe, MnF₂, FeF₂, FeCl₂, FeO, CoCl₂, CoO, NiCl₂, NiO, and Cr. Among these materials, MnTe (307 K), FeO (298 K), CoO (291 K), and Cr (308 K), which have Neel temperatures of 0°C or higher, are preferred because their antiferromagnetism can be easily utilized.

(6) In a still further preferred embodiment of the anisotropic electroconductive film according to the present invention, the particle is an approximately spherical particle with a diameter in a range from approximately 0.1 µm to approximately 10 µm, and is formed by aggregated microparticles made of a substance exhibiting topological antiferromagnetic properties;
wherein the surface of the approximately spherical particle has microprotrusions (irregularities) formed by the microparticles; the microprotrusions (irregularities) forming height differences in a range from approximately 10 nm to approximately 100 nm.

In this embodiment, there is an advantage that many defects (microvoids, lattice defects, impurities, etc.) that function as paths for magnetic flux and spin currents can be incorporated into the microparticle which is made of the electrically insulative substance exhibiting topological antiferromagnetic properties, and that many similar defects can be left in the particle also which is formed by the aggregated microparticles.

(7) In a still further preferred embodiment of the anisotropic electroconductive film according to the present invention, the electrically insulative thin film has a thickness less than twice a median diameter of the particles.

In this embodiment, because the thickness of the electrically insulative thin film is less than twice the median diameter of the particles, the individual particles are reliably arranged at intervals in the electrically insulative thin film in the in-plane direction thereof. Therefore, there is an advantage that a film (i.e., single particle film) in which the individual particles are arranged in a row at intervals within the electrically insulative thin film is reliably produced.

(8) In a still further preferred embodiment of the anisotropic electroconductive film according to the present invention, the magnetic anisotropy of the particle is imparted by applying, during a formation process of the electrically insulative thin film, a magnetic field of strength (e.g., 10^{2 ± 1} gauss) within a range from a critical magnetic field Hc1 at which an applied magnetic field begins to enter the particle to a critical magnetic field Hc2 at which magnetization saturates in a direction of the magnetic field and a direction of the magnetization begins to become disordered.

In this embodiment, since excessive aggregation of the particles is suppressed during the formation process of the electrically insulative thin film, the risk of the particles flowing in the in-plane direction of the electrically insulative thin film is eliminated. Accordingly, there is an advantage that generation of spin currents in the conduction portions can be ensured.

(9) An electroconductive connector according to the present invention is an electroconductive connector for use in a testing apparatus, in which electrical signals are transmitted and received between a test object and the testing apparatus in a state where the electroconductive connector is in contact with terminals of the test object; which comprises:
a first anisotropic electroconductive film formed by the anisotropic electroconductive film described in any one of the aforementioned (1) to (8);
a second anisotropic electroconductive film formed by the anisotropic electroconductive film described in any one of the aforementioned (1) to (8), the second anisotropic electroconductive film being stacked on the first anisotropic electroconductive film; and
movable electrodes disposed between the first anisotropic electroconductive film and the second anisotropic electroconductive film, the movable electrodes being movable in a stacking direction of the second anisotropic electroconductive film;
wherein the movable electrodes are positioned so as to align to positions of the terminals.

The electroconductive connector according to the present invention is configured to include the first anisotropic electroconductive film which is formed by the anisotropic electroconductive film described in any one of the aforementioned (1) to (8), the second anisotropic electroconductive film which is formed by the anisotropic electroconductive film described in any one of the aforementioned (1) to (8) and which is stacked on the first anisotropic electroconductive film, and the movable electrodes which are disposed between the first anisotropic electroconductive film and the second anisotropic electroconductive film and which are movable in the stacking direction of the second anisotropic electroconductive film. For this reason, when a pressure is applied in the stacking direction while the said electroconductive connector is sandwiched between the testing apparatus and the test object, each of the movable electrodes is contacted with and electrically connected to one or more of the conduction portions of the first anisotropic electroconductive film corresponding thereto and is contacted with and electrically connected to one or more of the conduction portions of the second anisotropic electroconductive film corresponding thereto. Therefore, by transmitting and receiving electrical signals between the test object and the testing apparatus, a desired test for the test object can be performed using the testing apparatus.

Since each of the first anisotropic electroconductive film and the second anisotropic electroconductive film is formed by the anisotropic electroconductive film described in any one of the aforementioned (1) to (8), the electrical resistance of the first anisotropic electroconductive film and that of the second anisotropic electroconductive film are extremely low because of the same reason as described for the anisotropic electroconductive film of the aforementioned (1). For example, these electrical resistances are at an extremely low level which is comparable to the level at which superconductivity occurs. Since the electrical resistance of the electroconductive connector according to the present invention is given by simply adding the electrical resistance of the movable electrodes to the extremely low electrical resistances of the first anisotropic electroconductive film and the second anisotropic electroconductive film, the electrical resistance of the said electroconductive connector is also kept at a level just slightly greater than the sum of the electrical resistance of the first anisotropic electroconductive film and that of the second anisotropic electroconductive film.

In addition, since such the extremely low electrical resistance as described above is achieved for the first anisotropic electroconductive film and the second anisotropic electroconductive film, the high-frequency characteristics of the said anisotropic electroconductive film are improved and the electrical current capacity thereof also can be increased.

Moreover, because of the same reasons as described above for the anisotropic electroconductive film of the aforementioned (1), even higher resolution than the prior art can be achieved, which makes it possible to accommodate the finer pitches that will result from further miniaturization and higher integration for the future ICs.

Furthermore, because of the same reasons as described above for the anisotropic electroconductive film in the aforementioned (1), by simply applying an extremely low pressure in the stacking direction while the said electroconductive connector is sandwiched between the testing apparatus and the test object, in other words, by using an extremely small contact pressure, each of the movable electrodes is electrically connected to one or more of the conduction portions of the first anisotropic electroconductive film corresponding thereto and to one or more of the conductive portions of the second anisotropic electroconductive film corresponding thereto. Therefore, the contact stability is improved compared with the prior art.

Furthermore, as described above, by simply applying an extremely low pressure in the stacking direction while the said electroconductive connector is sandwiched between the testing apparatus and the test object, each of the movable electrodes is electrically connected to one or more of the conduction portions of the first anisotropic electroconductive film corresponding thereto and to one or more of the conduction portions of the second anisotropic electroconductive film corresponding thereto. For this reason, the amount of displacement of the first anisotropic electroconductive film and that of the second anisotropic electroconductive film can be made extremely small. Therefore, the durability of the said electroconductive connector is improved.

(10) In a preferred embodiment of the electroconductive connector according to the present invention, each of the movable electrodes is formed by a rigid material having a shape of an approximately circular plate;
the movable electrodes are configured to be movable between the first anisotropic electroconductive film and the second anisotropic electroconductive film without using a retaining layer; and
when a pressure is applied in the stacking direction while the said electroconductive connector is sandwiched between the test object and the testing apparatus, each of the movable electrodes is contacted with and electrically connected to one or more of the conduction portions of the first anisotropic electroconductive film corresponding thereto and is contacted with and electrically connected to one or more of the conduction portions of the second anisotropic electroconductive film corresponding thereto.

In this embodiment, each of the movable electrodes is formed by a rigid material having a shape of an approximately circular plate, and the movable electrodes are configured to be movable between the first anisotropic electroconductive film and the second anisotropic electroconductive film without using a retaining layer. Therefore, there is an advantage that the contact and electrical conduction of each of the movable electrodes with the one or more corresponding conduction portions of the first anisotropic electroconductive film and the one or more corresponding conduction portions of the second anisotropic electroconductive film are more reliable.

(11) In another preferred embodiment of the electroconductive connector according to the present invention, a third anisotropic electroconductive film stacked on the first anisotropic electroconductive film and the second anisotropic electroconductive film, the third anisotropic electroconductive film being located on a side of the first anisotropic conductive film or on a side of the second anisotropic conductive film, is further provided;
wherein the third anisotropic electroconductive film is formed by the anisotropic electroconductive film described in any one of the aforementioned (1) to (8).

In this embodiment, since the third anisotropic electroconductive film is additionally provided, there is an advantage that the amount of displacement of each of the first anisotropic electroconductive film, the second anisotropic electroconductive film, and the third anisotropic electroconductive film can be reduced when absorbing dimensional differences existing in the gap between the test object and the testing apparatus compared with the case where only the first anisotropic electroconductive film and the second anisotropic electroconductive film are provided.

(12) An electroconductive structure according to the present invention is an electroconductive structure that is usable as a conduction portion of an anisotropic electroconductive film, which comprises:
at least one approximately spherical particle formed by a substance exhibiting topological antiferromagnetic properties;
wherein the particle has magnetic anisotropy, and has a south pole region and a north pole region that are respectively formed at two ends thereof in a direction along the easy direction of magnetization;
and wherein a voltage is applied between the south pole region and the north pole region,
   (a) an inside and an interface of the microparticle enter a topological superconducting state,
   (b) a spin current flows in a site existing between the south pole region and the north pole region,
   (c) an electrical current flows in a site from an outside to the south pole region of the particle and a site from the outside to the north pole region of the particle, and
   (d) electrical current-spin current conversion occurs in the south pole region and the north pole region,
whereby electrical conduction through the particle is achieved.

In the electroconductive structure according to the present invention, since electrical conduction through the said electroconductive structure is achieved in such a way as described above, the electrical resistance of an anisotropic electroconductive film including the said electroconductive structure is extremely low. For example, this extremely low electrical resistance can be as low as when superconductivity occurs.

In addition, since such the extremely low electrical resistance is achieved, the high-frequency characteristics of the anisotropic electroconductive film is improved and the electrical current capacity thereof can be increased also.

Moreover, because the particle is formed by a material exhibiting topological antiferromagnetic properties and has magnetic anisotropy, it is possible to make the arrangement pitch of the conduction portions arranged in the anisotropic electroconductive film as fine as the diameter of the particle by orienting the easy direction of magnetization of the particle to a thickness direction of the anisotropic electroconductive film. Therefore, it is possible to realize higher resolution than the prior art and at the same time, it is also possible to accommodate finer pitches that will be required due to the further miniaturization and higher integration of ICs in the future.

Furthermore, it is conjectured that the spin current that flows in the particle passes through a potential barrier to achieve electrical conduction due to the quantum mechanical tunneling effect, without destroying an electrically insulative film, such as an oxide film, existing on the surface of a contact object such as an electrode or terminal or the like. Therefore, by simply pressing the contact object against the anisotropic electroconductive film with an extremely low pressure, in other words, by using an extremely small contact pressure, electrical conduction between the contact object and the conduction portions is accomplished. Accordingly, the contact stability is improved compared with the prior art.

Furthermore, as described above, by simply pressing the contact object against the anisotropic electroconductive film with an extremely low pressure or using an extremely small contact pressure, electrical conduction between the contact object and the conduction portions is accomplished. Therefore, the amount of displacement of the anisotropic electroconductive film can be reduced. Accordingly, the durability of the anisotropic electroconductive film is improved.

(13) In a preferred embodiment of the electroconductive structure according to the present invention, NiO (nickel oxide) or MnO (manganese oxide) is used as the substance exhibiting topological antiferromagnetic properties that forms the particle. In this case, it is preferred that metallic Ni or Mn refined by the carbonyl method is used as the source material from which NiO or MnO is derived. This is because according to the inventors' research, to the extent currently known, the most favorable results were obtained in terms of both exhibition of the electrical current-spin current conversion and exhibition of the functions of a type-II superconductor when metallic Ni or metallic Mn refined by the carbonyl method was used.

In addition to NiO and MnO, other usable materials include Cr₂O₃, Mn₃Ge, Mn₃Sn, MnS, MnTe, MnF₂, FeF₂, FeCl₂, FeO, CoCl₂, CoO, NiCl₂, NiO, and Cr. Among these materials, MnTe (307 K), FeO (298 K), CoO (291 K), and Cr (308 K), which have Neel temperatures of 0°C or higher, are preferred, because their antiferromagnetic properties can be easily utilized.

(14) In another preferred embodiment of the electroconductive structure according to the present invention, the particle is an approximately spherical particle which is formed by aggregated microparticles made of the substance exhibiting topological antiferromagnetic properties;
the particle has a diameter in a range from approximately 0.1 µm to approximately 10 µm, and
the surface of the particle has microprotrusions formed by the microparticles, the microparticles forming height differences in a range from approximately 10 nm to approximately 100 nm.

In this embodiment, there is an advantage that many defects (microvoids, lattice defects, impurities, etc.) that function as paths for magnetic flux and spin currents can be incorporated into the microparticle which is made of the substance exhibiting topological antiferromagnetic properties, and that many similar defects can be left in the particle also which is formed by the aggregated microparticles.

(15) In still another preferred embodiment of the electroconductive structure according to the present invention, the magnetic anisotropy of the particle is imparted by applying, during a formation process of the electrically insulative thin film, a magnetic field of strength (e.g., 10^{2 ± 1} gauss) within a range from a critical magnetic field Hc1 at which an applied magnetic field begins to enter the particle to a critical magnetic field Hc2 at which magnetization saturates in a direction of the magnetic field and a direction of the magnetization begins to become disordered.

In this embodiment, since excessive aggregation of the particle is suppressed during the formation process of the electrically insulative thin film, the risk of the particle flowing in the in-plane direction of the electrically insulative thin film is eliminated. Accordingly, there is an advantage that generation of spin currents in the particle can be ensured.

### ADVANTAGEOUS EFFECTS OF THE INVENTION

In the anisotropic electroconductive film, the electroconductive connector, and the electroconductive structure according to the present invention, there are the advantageous effects that the electrical resistance can be lowered, the high-frequency characteristics can be improved, the resolution can be raised, the contact stability can be improved through the reduction of the contact pressure, the electrical current capacity can be increased, and the durability can be improved compared with the prior art.

### BRIEF DESCRIPTION OF THE DRAWINGS

Fig. 1A is a schematic cross-sectional view showing an electroconductive connector according to a first embodiment of the present invention in use, Fig. 1B is a schematic exploded explanatory view showing the structure of the electroconductive connector, and Fig. 1C is a conceptual diagram showing a cluster dispersed in an anisotropic electroconductive film (cluster film) of the electroconductive connector.

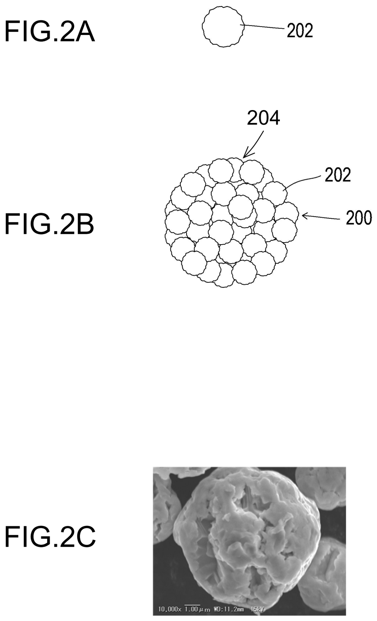

Fig. 2A is an explanatory view showing a microparticle that forms particles dispersed in the anisotropic electroconductive film (single particle film and cluster film) used in the electroconductive connector of Fig.1A, Fig. 2B is a conceptual diagram showing the structure of the particle, and Fig. 2C is an electron microscope photograph of the particle.

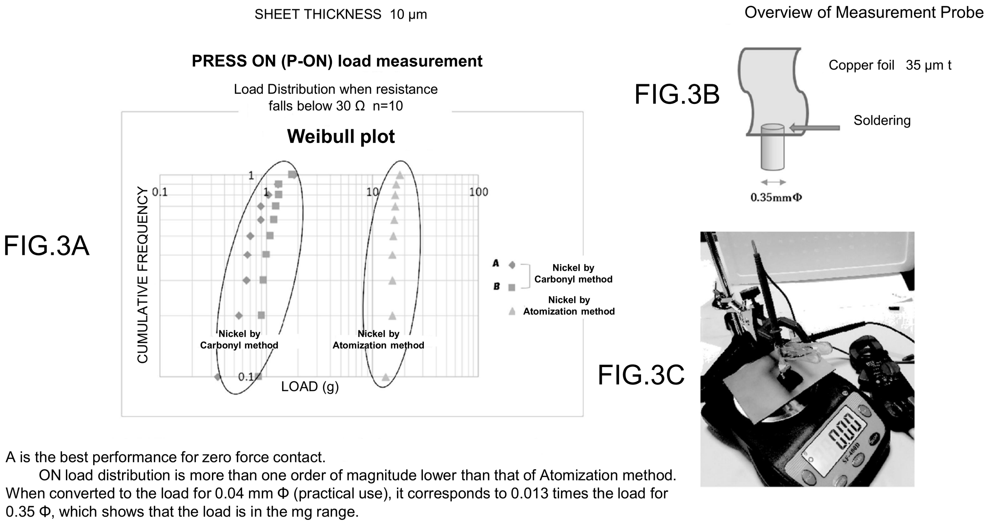

Fig. 3A is a graph comparing the PRESS-ON load measured when the particle shown in Fig. 2B was manufactured by the carbonyl method and the atomization method, Fig. 3B is a diagram showing the overview of a measurement probe, and Fig. 3C is a photograph of the exterior of a measurement device used to measure the PRESS-ON load (the load at which electrical conduction begins due to pressure).

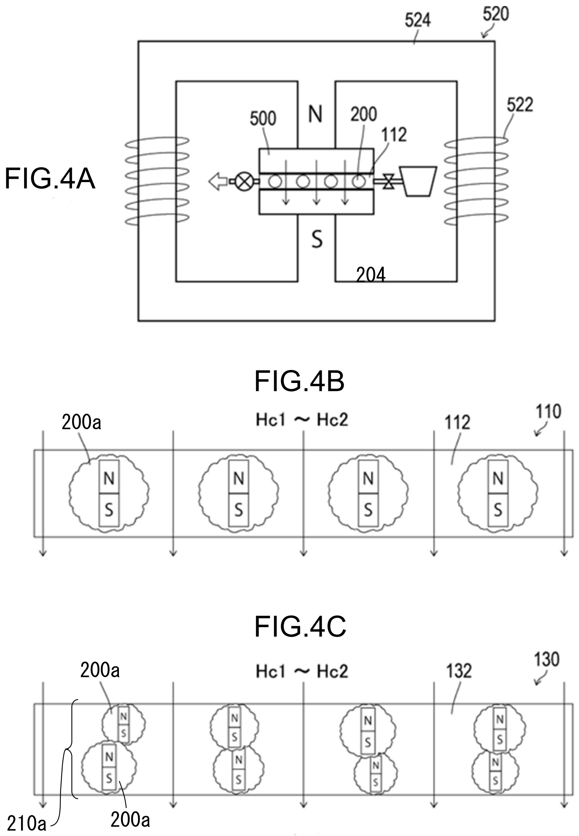

Figs. 4A to 4C are diagrams showing a manufacturing method of the anisotropic electroconductive films (single particle film and cluster film) used in the electroconductive connector of Fig. 1A, in which Fig. 4A is a conceptual diagram of a manufacturing apparatus used in the manufacturing method, Fig. 4B is a conceptual diagram showing a magnetization state of the particles within the single particle film, and Fig. 4C is a conceptual diagram showing a magnetization state of the particles within the cluster film.

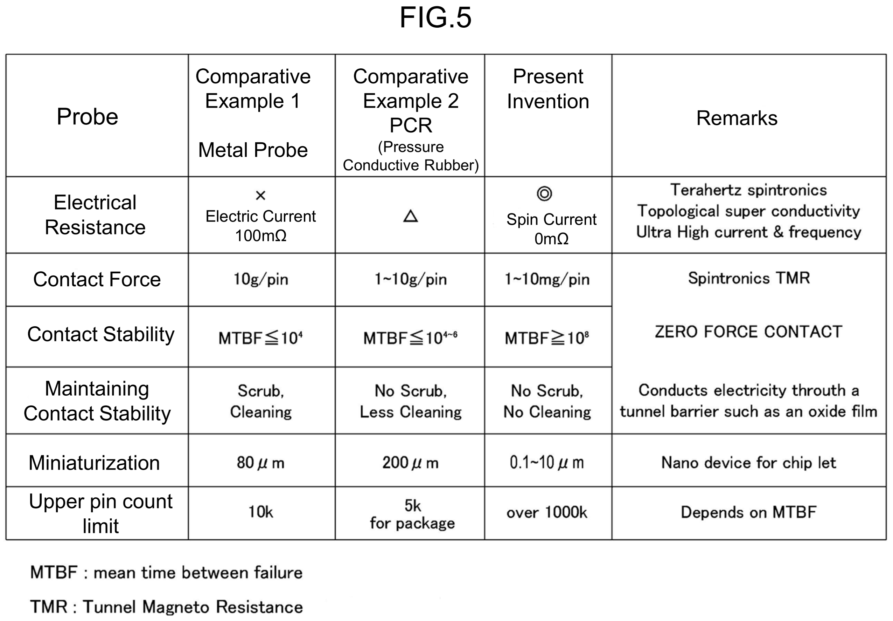

Fig. 5 is a table showing the results of tests comparing the various performances of a probe manufactured using the electroconductive connector of Fig. 1A with those of probes of Comparative Examples 1 and 2.

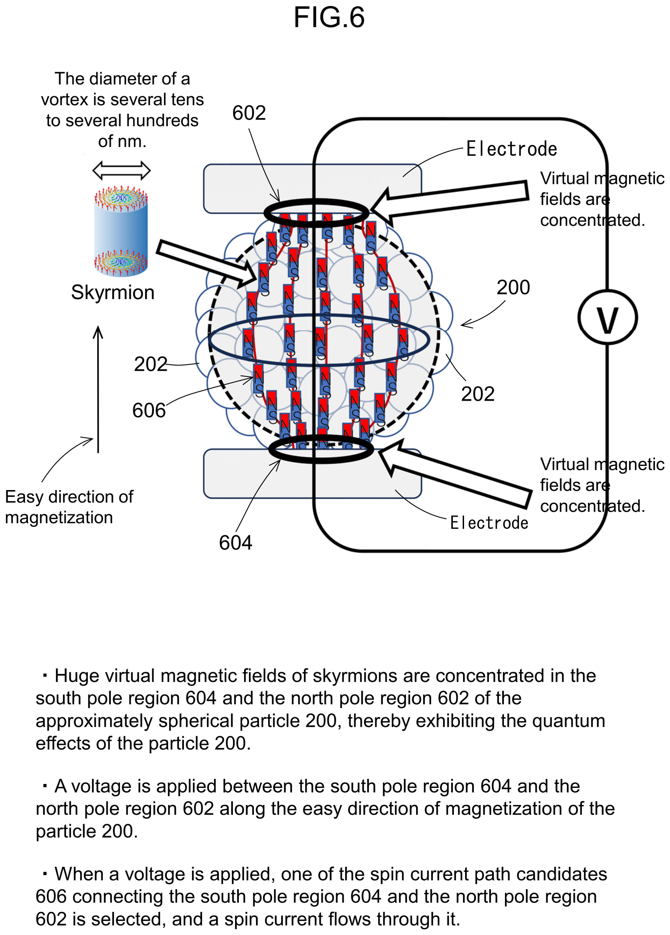

Fig. 6 is an explanatory diagram showing that when a voltage is applied between a south pole region and a north pole region of the particle (in which skyrmions are generated in a concentrated manner) contained in the anisotropic electroconductive film (single particle film, cluster film) used in the electroconductive connector of Fig. 1A, huge virtual magnetic fields of skyrmions are concentrated in the south pole region and the north pole region to thereby cause the quantum effects of the said particle and as a result, one of the spin current path candidates generated between the south pole region and the north pole region is selected and a spin current flows through the spin current path candidate thus selected.

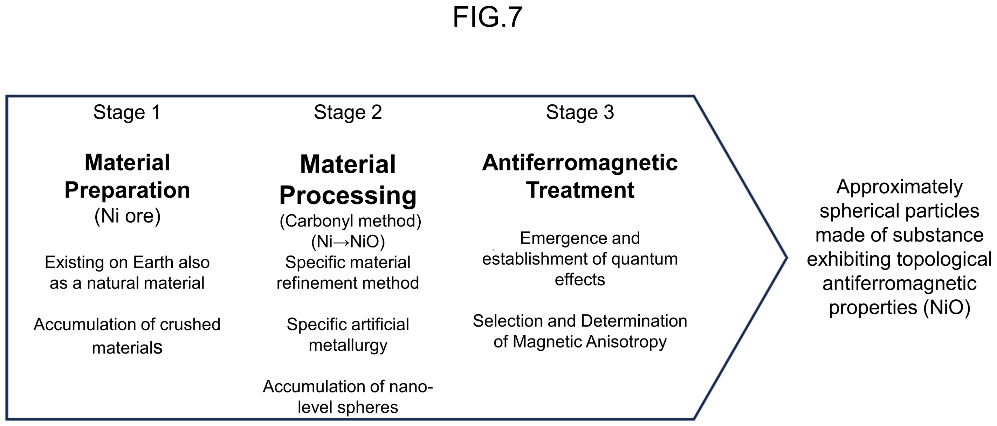

Fig. 7 is an explanatory diagram showing an outline of the manufacturing process of the anisotropic electroconductive film (single particle film, cluster film) used in the electroconductive connector of Fig. 1A.

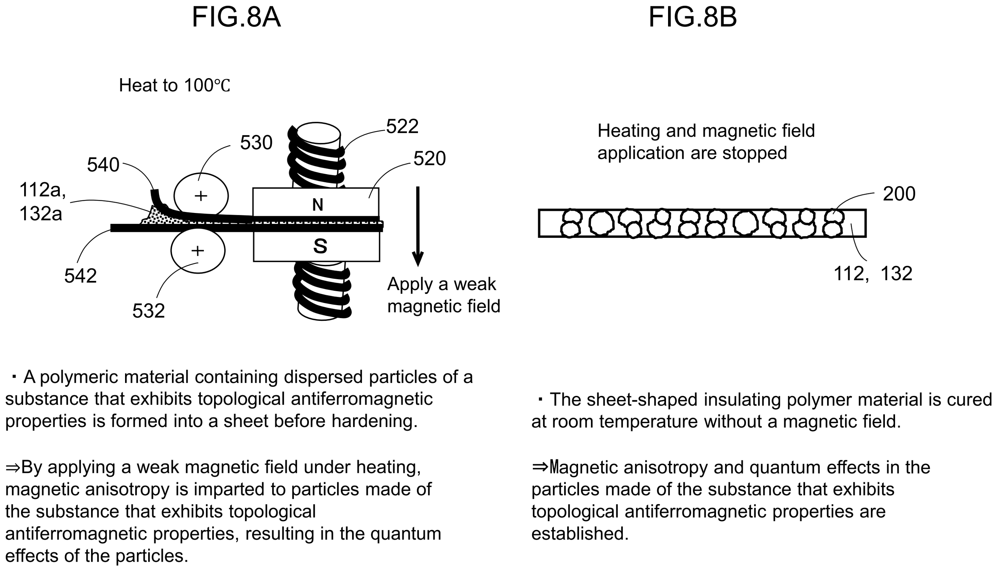

Figs. 8A and 8B are explanatory diagrams showing an outline of the manufacturing process of the anisotropic electroconductive film (single particle film, cluster film) used in the electroconductive connector of Fig. 1A.

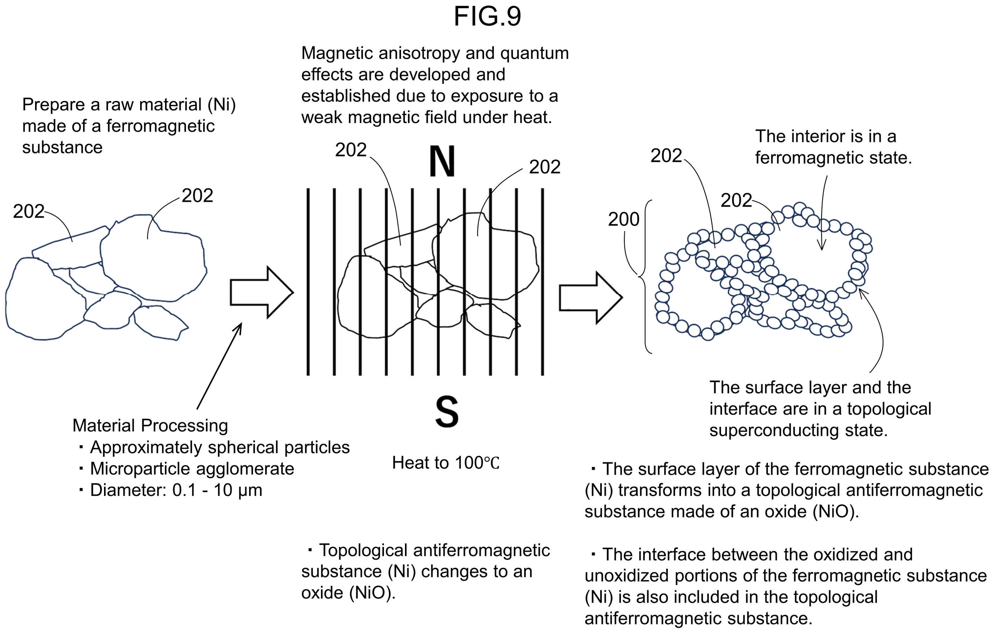

Fig. 9 is an explanatory diagram showing the process of imparting magnetic anisotropy and quantum effects to the particle (and the microparticles that form it) contained in the anisotropic electroconductive film (single particle film, cluster film) used in the electroconductive connector of Fig. 1A, and showing that the surface layer and the interface of the particle (and the microparticles) enter a topological superconducting state and the interior thereof is kept in a ferromagnetic state due to the magnetic anisotropy and the quantum effects.

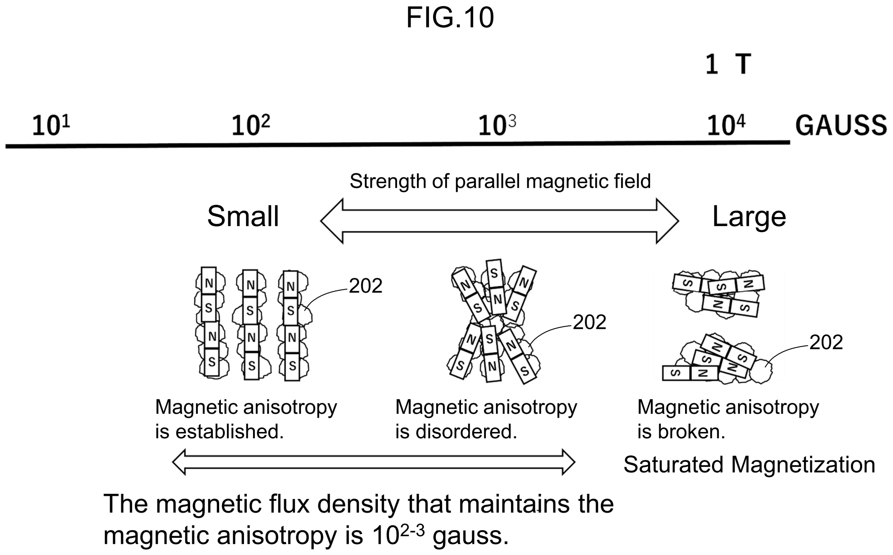

Fig. 10 is an explanatory diagram showing how the magnetic anisotropy imparted to the particle (and the microparticles that form it) contained in the anisotropic electroconductive film (single particle film, cluster film) used in the electroconductive connector of Fig. 1A changes depending on the strength of the applied magnetic field.

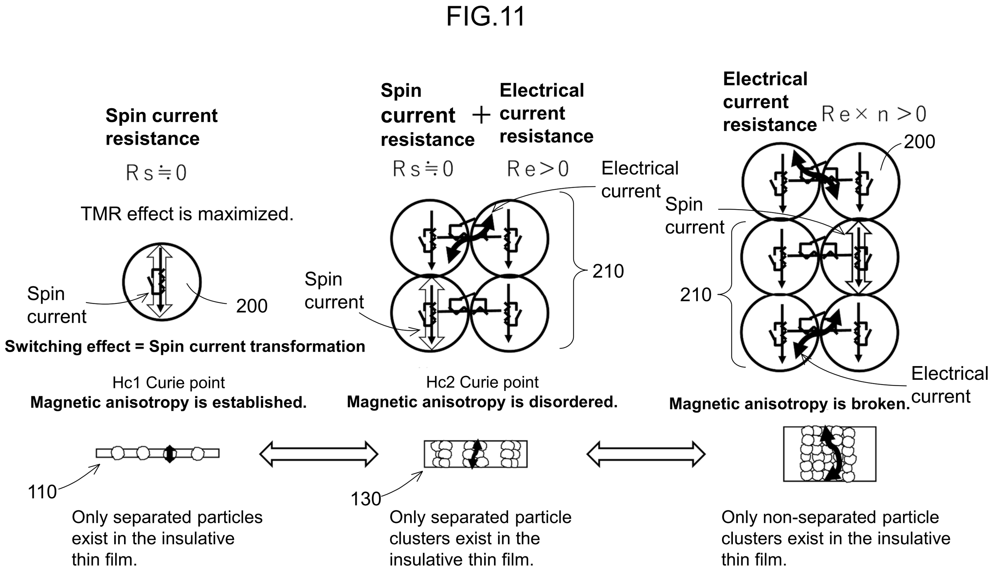

Fig. 11 is an explanatory diagram showing that the formation situations of spin current paths and electrical current paths differ depending on the magnetic anisotropy imparted to the particle in the cases where only separated particles are contained in the anisotropic electroconductive film (single particle film, cluster film) used in the electroconductive connector of Fig. 1A, only separated particle clusters are contained therein, and only non-separated particle clusters are contained therein.

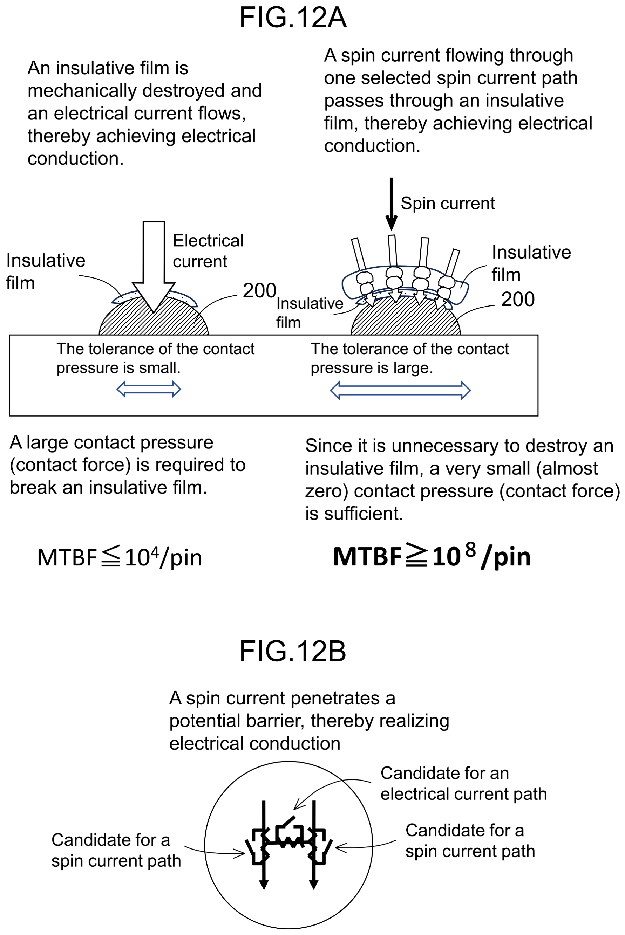

Fig. 12A is an explanatory diagram showing, in comparison with the prior art, how electrical conduction is achieved by a spin current that penetrates the electrically insulative film of the particle contained in the anisotropic electroconductive film (single particle film, cluster film) used in the electroconductive connector of Fig. 1A, and Fig. 12B is an explanatory diagram showing schematically the electrical current paths and the spin current paths formed in the particle.

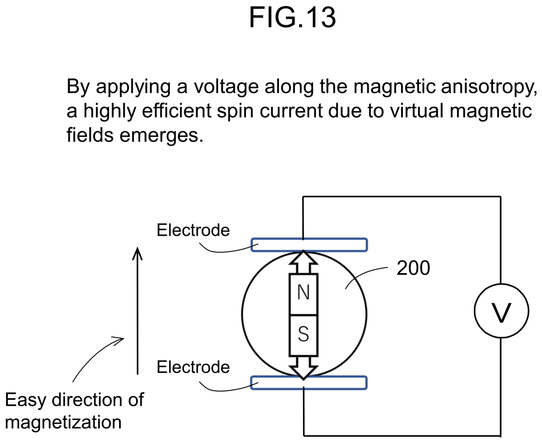

Fig. 13 is an explanatory diagram showing that a highly efficient spin current is generated by applying a voltage to the particle contained in the anisotropic electroconductive film (single particle film, cluster film) used in the electroconductive connector of Fig. 1A along the magnetic anisotropy thereof.

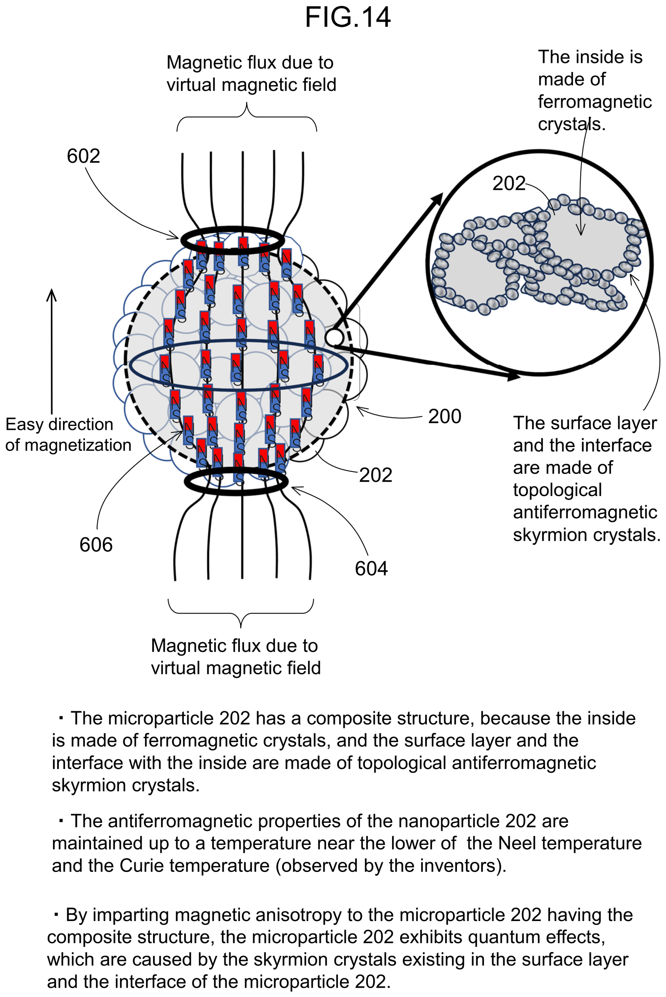

Fig. 14 is an explanatory diagram showing the south pole region and the north pole region in which skyrmions are generated in a concentrated manner and the spin current path candidates generated between the south pole region and the north pole region in the particle contained in the anisotropic electroconductive film (single particle film, cluster film) used in the electroconductive connector of Fig. 1A.

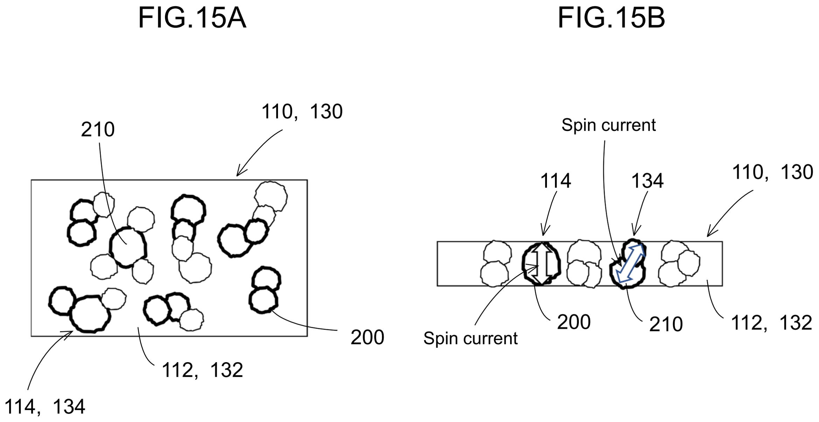

Fig. 15A is an explanatory plan view of the anisotropic electroconductive film (single particle film, cluster film) used in the electroconductive connector of Fig. 1A, and Fig. 15B is a cross-sectional view thereof, both of which show schematically that a spin current flows through a selected one of the spin current path candidates.

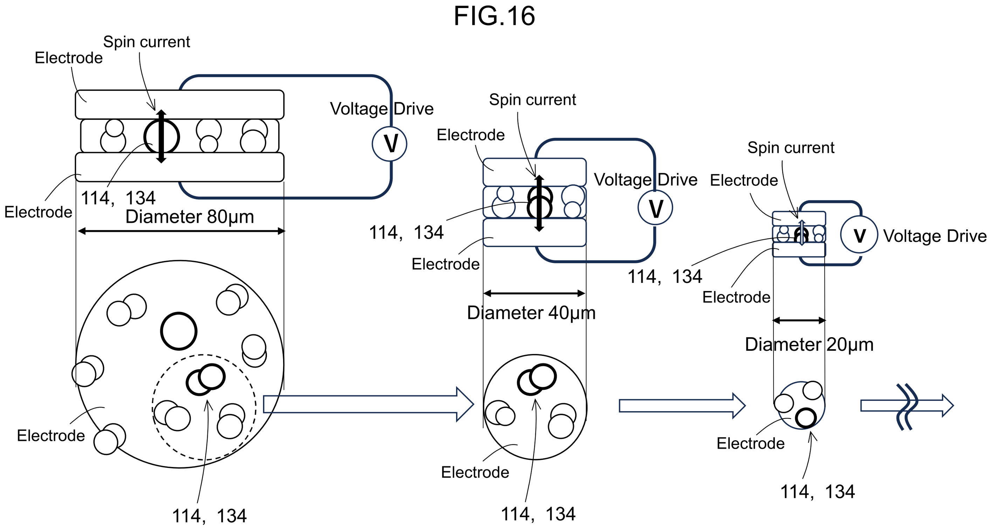

Fig.16 is an explanatory diagram showing that a spin current flows through one of the conduction portions having different sizes in the anisotropic electroconductive film (single particle film, cluster film) used in the electroconductive connector of Fig. 1.

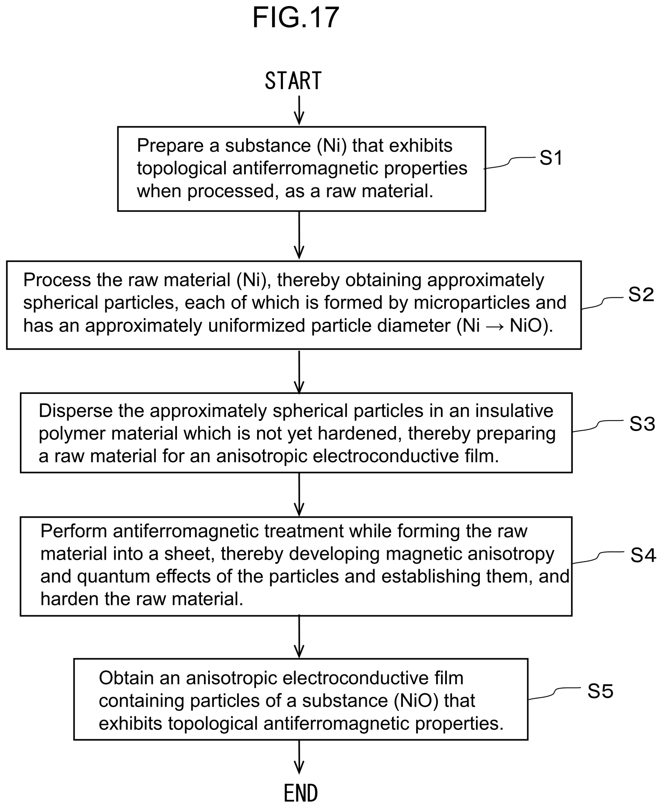

Fig. 17 is a flowchart showing an outline of a method of manufacturing the anisotropic electroconductive film (single particle film, cluster film) used in the electroconductive connector of Fig. 1.

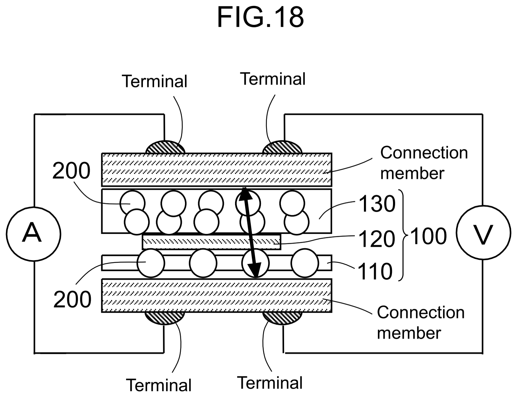

Fig. 18 is an explanatory diagram showing an example of the circuit configuration for measuring the electrical resistance of the electroconductive connector of Fig. 1A using the four-terminal measurement method.

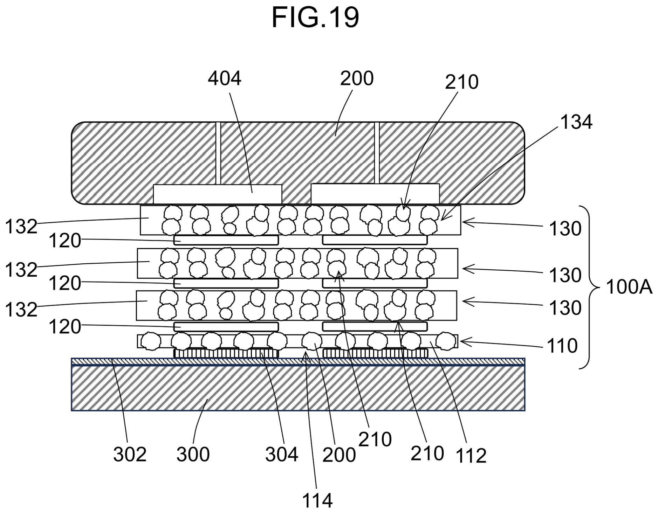

Fig. 19 is a schematic cross-sectional view showing the structure of an electroconductive connector according to a second embodiment of the present invention.

### EMBODIMNENTS FOR CARRYING OUT THE INVENTION

Hereinafter, preferred embodiments of the present invention will be described with reference to the accompanying drawings. It should be noted that the dimensions, materials, specific values, etc. shown in the embodiments are merely examples to facilitate understanding of the present invention, and do not limit the present invention unless otherwise specified. Furthermore, elements having substantially the same functions and structures are assigned the same reference signs to avoid redundant explanation, and elements not directly related to the present invention are not shown.

### (Structure of electroconductive connector 100 according to first embodiment of present invention)

To facilitate understanding, the following will first explain an electroconductive connector 100 according to a first embodiment of the present invention, followed by a description of a first anisotropic electroconductive film 110, a second anisotropic electroconductive film 130, and movable electrodes 120 which are used in the electroconductive connector 100.

Fig. 1A is a schematic diagram showing the electroconductive connector 100 according to the first embodiment of the present invention in use, and Fig. 1B is an explanatory exploded view illustrating the structure of the electroconductive connector 100. Fig. 1C is a conceptual diagram illustrating particles 200 and a cluster 210 thereof used in the electroconductive connector 100.

In wafer tests during the manufacturing process of ICs, the operation of a circuit 302 constituting each of ICs formed on a silicon wafer 300 as a test object is confirmed. The electroconductive connector 100 shown in Fig. 1A is used as a probe provided on a test head 400 of a semiconductor testing apparatus (not shown). When performing a wafer test, a plurality of terminals 304 of the circuit 302 on the wafer 300 are electrically connected to a plurality of electrodes 404 of the test head 400 corresponding to the terminals 304 via the electroconductive connector 100 and then, electrical signals are transmitted and received between the semiconductor testing apparatus and the circuit 302 in the connected state, thereby testing the electrical characteristics of the circuit 302. The electroconductive connector 100 according to the first embodiment of the present invention is used for such an application.

The electroconductive connector 100 according to the first embodiment of the present invention has the following structure. Specifically, as shown in Fig. 1A, from the circuit 302 on the wafer 300 toward the test head 400 of the semiconductor testing apparatus (upward in Fig. 1A), a single particle film (a first anisotropic electroconductive film) 110, a plurality of movable electrodes 120 each having a shape of a circular plate (coin tablet-shaped), and a cluster film (a second anisotropic electroconductive film) 130 are stacked in this order, forming a three-layer structure. The circular plate-shaped movable electrodes 120 are arranged at intervals in a single plane within the space between the single particle film 110 and the cluster film 130, and are approximately parallel to the single particle film 110 and the cluster film 130. The single particle film 110 and the cluster film 130 are also approximately parallel to each other.

Each of the electrodes 404 of the test head 400 is located at a position superposed on the terminal 304 located at a corresponding position thereto (i.e., directly below) on the wafer 300. Each of the movable electrode 120 is located at a position superposed on both the electrode 404 of the test head 400 located at a corresponding position thereto (i.e., directly above) and the terminal 304 on the wafer 300 located at a corresponding position thereto (i.e., directly below).

As shown in Figs. 1A and 1B, the first anisotropic electroconductive film 110 has a structure that separated particles 200 in the separated state are arranged at intervals in the in-plane direction thereof, and only the single particle 200 exists in the thickness direction thereof. Therefore, in the following description, the first anisotropic electroconductive film 110 is also referred to as a single particle film.

As shown in Fig. 1B, the single particle film (the first anisotropic electroconductive film) 110 has a structure that the particles 200 are dispersed so as to form a single particle layer within an electrically insulative thin film 112 made of an elastic electrically insulative polymer material. Within the electrically insulative thin film 112, the particles 200 are arranged at intervals along the in-plane direction of the electrically insulative thin film 112, but only the single, or, isolated particle 200 exists in the thickness direction of the electrically insulative thin film 112. In other words, any cluster 210 of the particles 200 does not exist within the electrically insulative thin film 112.

The isolated particles 200 existing in the electrically insulative thin film 112 are arranged at intervals along the in-plane direction of the electrically insulative thin film 112, thereby forming conduction portions 114 that make it possible to achieve electrical conduction in the thickness direction of the electrically insulative thin film 112. The distance between the two adjacent particles 200 is set at a value such that, even when the single particle film 110 is brought into contact with the terminals 304 on the wafer 300 and then, electrical conduction occurs in the thickness direction of the electrically insulative thin film 112 at the conduction portions 114 formed by the particles 200, electrical conduction does not occur between the particles 200 (the conduction portions 114) in the in-plane direction of the electrically insulative thin film 112.

As shown in Fig. 1B, the upper and lower ends of each particle 200 (i.e., each conduction portion 114) are exposed on the upper and lower surfaces of the electrically insulative thin film 112, respectively. Therefore, the upper end of each particle 200, i.e., each conduction portion 114, is always in contact with the movable electrode 120 located at a corresponding position thereto (i.e., directly above). On the other hand, the lower end of each particle 200, i.e., each conduction portion 114, can be brought into contact with the terminal 304 on the wafer 300 located at a corresponding position thereto (i.e., directly below). When the lower end of each conduction portion 114 is brought into contact with the terminal 304 on the wafer 300 located at a corresponding position thereto (directly below) and then, a voltage is applied between the two ends of the said conduction portion 114 (the said particle 200), quantum effects of the said particle 200 are exerted, thereby causing a flow of electron spins (a spin current) to pass through the said conduction portion 114 (the said particle 200) in the vertical direction (in the thickness direction of the electrically insulative thin film 112). As a result, electrical conduction can be achieved between the movable electrode 120 located at a corresponding position (i.e., directly above) to the said conduction portion 114 (the said particle 200) and the terminal 304 located at a corresponding position (i.e., directly below) to the said conduction portion 114 (the said particle 200). Details of the quantum effects of the said particle 200 will be described later.

Different from the first anisotropic electroconductive film 110, the second anisotropic electroconductive film 130 has a structure that aggregations of the particles 200 in which the plurality of particles 200 (two particles in Figs. 1A and 1B) are aggregated in the thickness direction thereof, i.e., clusters 210 of the particles 200, are arranged at intervals in the in-plane direction thereof, and only the single cluster 210 exists in the thickness direction thereof. Therefore, in the following description, the second anisotropic electroconductive film 130 is also referred to as a cluster film.

As shown in Fig. 1B, the cluster film 130 has a structure that the particles 200, which are the same as those used in the single particle film 110, are dispersed in an electrically insulative thin film 132 made of an elastic electrically insulative polymer material. Within the electrically insulative thin film 132, the particles 200 are arranged at intervals along the in-plane direction of the electrically insulative thin film 132. This is similar to the single particle film 110. However, within the electrically insulative thin film 132, the plurality of particles 200 (two particles here) are aggregated in the thickness direction of the electrically insulative thin film 132 to form the cluster 210, and such the clusters 210 of the particles 200 are arranged at intervals along the in-plane direction of the electrically insulative thin film 132. In this respect, the cluster film 130 is different from the single particle film 110.

In addition, only the clusters 210 of the particles 200 exist in the cluster film 130. In other words, there are no particles 200 separated from one another, which are present in the single particle film 110, in the electrically insulative thin film 132. Therefore, it can be said that the clusters 210 of the particles 200 are arranged at intervals along the in-plane direction of the electrically insulative thin film 132 within the said film 112.

The clusters 210 of the particles 200 existing in the electrically insulative thin film 132 are arranged at intervals along the in-plane direction of the electrically insulative thin film 132, thereby forming conduction portions 134 that make it possible to achieve electrical conduction in the thickness direction of the electrically insulative thin film 132. The distance between the two adjacent clusters 210 is set at a value such that, even when the cluster film 130 is brought into contact with the electrodes 404 of the test head 400 and then, electrical conduction occurs in the thickness direction of the electrically insulative thin film 132 at the conduction portions 134 formed by the clusters 210, electrical conduction does not occur between the clusters 210 (the conduction portions 134) in the in-plane direction of the electrically insulative thin film 132.

As shown in Fig. 1B, the upper and lower ends of each cluster 210 (i.e., each conduction portion 134) are exposed on the upper and lower surfaces of the electrically insulative thin film 132, respectively. Therefore, the lower end of each cluster 210, i.e., each conduction portion 134, is always in contact with the movable electrode 120 located at a corresponding position thereto (i.e., directly below). On the other hand, the upper end of each cluster 210, i.e., each conduction portion 134, can be brought into contact with the electrode 404 of the test head 400 located at a corresponding position thereto (i.e., directly above). When the upper end of each conduction portion 134 is brought into contact with the electrode 404 of the test head 400 located at a corresponding position thereto (directly above) and then, a voltage is applied between the two ends of the said conduction portion 134 (the said cluster 210), quantum effects of the particles 200 contained in the said cluster 210 are exerted, thereby causing a flow of electron spins (a spin current) to pass through the said conduction portion 134 (the said cluster 210) in the vertical direction (in the thickness direction of the electrically insulative thin film 132). As a result, electrical conduction can be achieved between the movable electrode 120 located at a corresponding position (i.e., directly below) to the said conduction portion 134 (the said cluster 210) and the electrode 404 located at a corresponding position (i.e., directly above) to the said conduction portion 134 (the said cluster 210). This is similar to the single particle film 110. Details of the quantum effects of the particles 200 contained in the said cluster 210 will be described later.

The clusters 210 of the particles 200 can be easily formed by applying a magnetic field in the thickness direction of the cluster film 130 (electrically insulative thin film 132) when forming the cluster film 130. This is because the particles 200 can be aggregated in rows in the direction of the applied magnetic field, i.e., in the thickness direction of the cluster film 130 (electrically insulative thin film 132) by the applied magnetic field.

In addition, if the strength of the applied magnetic field is excessive, more particles 200 than desired will aggregate in the electrically insulative thin film 132 during the film formation (prior to curing), resulting in clumps rather than rows. Furthermore, if many particles 200 form clumps, there is a high possibility of electrical conduction occurring in the in-plane direction of the cluster film 130. Therefore, when forming the cluster film 130, it is preferable to apply a magnetic field with an appropriate strength (for example, 10^{2±1} gauss) within the range from a critical magnetic field Hc1 at which the applied magnetic field begins to enter the particles 200 existing in the cluster film 130 to another critical magnetic field Hc2 at which the magnetization becomes saturated in the direction of the applied magnetic field and the direction of the magnetization begins to become distorted.

The electroconductive connector 100 shown in Figs. 1A and 1B is structured using the single particle film (first anisotropic electroconductive film) 110 and the cluster film (second anisotropic electroconductive film) 130, in other words, two anisotropic electroconductive films according to the present invention. However, the present invention is not limited to this. Three or more anisotropic electroconductive films according to the present invention may also be used. Conventionally, a method of stacking a plurality of anisotropic electroconductive films has been used to absorb the dimensional difference between the terminals 304 of the circuit 302 on the wafer 300 and the electrodes 404 of the test head 400 of the semiconductor testing apparatus. In this case, by using three or four or more of the anisotropic electroconductive films according to the present invention, there is an advantage that the amount of displacement of the anisotropic electroconductive film of each layer can be further reduced compared with the electroconductive connector 100 according to the first embodiment in which two of the anisotropic electroconductive films according to the present invention are used. For this reason, the contact pressures applied to the anisotropic electroconductive film of each layer and the terminals 304 and the electrodes 404 are lowered and at the same time, the durability of the electroconductive connector 100 is increased. (An electroconductive connector using three or more of the anisotropic electroconductive films according to the present invention will be described in detail in a second embodiment of the present invention described later.)

From the standpoint of electrical insulation and durability, it is preferable to use a polymer material with a cross-linked structure for both the electrically insulative thin film 112 used for the single particle film 110 and the electrically insulative thin film 132 used for the cluster film 130. Specifically, room-temperature curing silicone rubber is suitable; however, polymer materials other than silicone rubber can also be used as long as they have electrical insulation and a cross-linked structure. For example, as described in Japanese Patent No. 5777477 which is owned by the present applicant, examples of suitable materials include conjugated diene rubbers such as polybutadiene rubber, natural rubber, polyisoprene rubber, styrene-butadiene copolymer rubber, and acrylonitrile-butadiene copolymer rubber, as well as hydrogenated versions of these; block copolymer rubbers such as styrene-butadiene-diene block copolymer rubber, and styrene-isoprene block copolymer rubber, as well as hydrogenated versions of these; and chloroprene rubber, urethane rubber, polyester rubber, epichlorohydrin rubber, silicone rubber, ethylene-propylene copolymer rubber, and ethylene-propylene-diene copolymer rubber.

Since the single particle film (first anisotropic electroconductive film) 110 has the structure in which the particles 200 are dispersed in the electrically insulative thin film 112 made of the elastic electrically insulative polymer material, the single particle film 110 has flexibility (changeability) in its thickness direction. In other words, when a pressure is applied to an arbitrary location, the thickness of the single particle film 110 at that location varies (decreases) in response to the pressure, and returns to its original thickness when the pressure is removed. However, the single particle film 110 does not expand or contract in its in-plane direction (i.e., it is inelastic in the in-plane direction). Therefore, the single particle film 110 can absorb the dimensional errors among the spaces existing between the terminals 304 on the wafer 300 and the movable electrodes 120, which ensures reliable contact with the terminals 304 and the movable electrodes 120 which are respectively located on the two sides of the single particle film 110.

The cluster film (second anisotropic electroconductive film) 130 is similar to the single particle film 110. Specifically, since the cluster film 130 has the structure in which the clusters 210 of the particles 200 are dispersed in the electrically insulative thin film 132 made of the elastic electrically insulative polymer material, the cluster film 130 has flexibility (changeability) in its thickness direction; however, the cluster film 130 does not expand or contract in its in-plane direction (i.e., it is inelastic in the in-plane direction). Therefore, the cluster film 130 can absorb the dimensional errors among the spaces existing between the electrodes 404 of the test head 400 and the movable electrodes 120, which ensures reliable contact with the electrodes 404 and the movable electrodes 120 which are respectively located on the two sides of the cluster film 130.

Accordingly, the single particle film 110 and the cluster film 130 can absorb the dimensional errors among the spaces relating to the terminals 304 and the electrodes 404, respectively. As a result, the single particle film 110 can be reliably contacted with the terminals 304 and the movable electrodes 120 which are respectively located on the two sides of the single particle film 110, and the cluster film 130 can be reliably contacted with the electrodes 404 and the movable electrodes 120 which are respectively located on the two sides of the cluster film 130.

Here, the movable electrodes 120 have a shape of a circular plate (coin tablet-shaped). The movable electrodes 120 are arranged at positions corresponding to the pattern of the terminals 304 on the wafer 300 and the pattern of the electrodes 404 of the test head 400, in other words, arranged so as to form the same pattern as these two patterns. A retaining layer for retaining the movable electrodes 120 is not provided; only the movable electrodes 120 are arranged so as to form a layer in the space existing between the single particle film 110 and the cluster film 130. Accordingly, it can be said that the movable electrodes 120 form a movable electrode layer.

Any metallic material having rigidity and desired electrical conductivity may be preferably used for the movable electrode 120. For example, elemental metals such as nickel (Ni), cobalt (Co), gold (Au), and aluminum (AI), as well as alloys of these metals may be used for this purpose.

In addition, it is necessary for the thickness (height) of each movable electrode 120 to be equal to 25% or less of the total thickness of the single particle film 110 and the cluster film 130 which is stacked on the film 110 (both of which are anisotropic electroconductive films). This is to ensure high durability of each of the single particle film 110 and the cluster film 130 by preventing each of the single particle film 110 and the cluster film 130 from being damaged due to application of excessive pressure.

Further in addition, the displacement (compression amount) of the cluster film 130 located on the side of the test head 400 is calculated by multiplying the thickness of the cluster film 130 by a compression ratio. It is preferred that this compression ratio is set to be equal to 5% or less of the thickness of the cluster film 130. Therefore, for example, if the thickness of the cluster film 130 is 10 µm, the compression amount of the cluster film 130 should be 5% of the thickness of the cluster film 130 at the maximum, i.e., 10 µm x 0.05 = 0.5 µm. In other words, it is preferred that the maximum value of the compression amount of the cluster film 130 is set at 0.5 µm. This is a necessary condition for achieving both zero-force contact and high reliability. In addition, if a plurality of cluster films 130 are located on the side of the test head 400, it is sufficient that the thickness of the cluster film 130 is replaced by the sum of the thicknesses of those cluster films 130.

The movable electrode 120 can be easily formed using known methods. For example, the method described in Japanese Patent No. 5777477 which is owned by the present applicant can be used for this purpose.

Specifically, for example, a through hole is first formed in an electrically insulative sheet (e.g., polyimide resin) and a mask layer is formed on the inner surface of the through hole (e.g., a Cu layer is formed by electroless plating). Thereafter, a rigid conductor is formed on the inside of the mask layer (e.g., by electroforming plating using Ni). Following this, a polymer material (e.g., silicone rubber) before cross-linking and curing, which contains particles (e.g., magnetic metal particles such as Fe, Co, Ni, or alloy particles thereof (particles containing these metals)), is coated so as to be in contact with the rigid conductor; thereafter, the polymer material is cross-linked and cured to form an elastic material, thereby forming an anisotropic electroconductive film (which forms the head portion of the movable electrode) connected to the rigid conductor. The mask layer is then removed by etching. In this way, the rigid conductor can be formed as a movable electrode that is movable relative to the electrically insulative sheet.

The anisotropic electroconductive film connected and integrated with the movable electrode (which is formed from the rigid conductor) forms the flange-shaped head portion of the movable electrode. However, if the anisotropic electroconductive film is not necessary, the step of coating the polymer material before cross-linking and curing that contains the aforementioned particles can be omitted. Moreover, in the state where the mask layer is removed, the electrically insulative sheet that supports and guides the movable electrode remains around the movable electrode. However, the electrically insulative sheet can be removed by etching or the like. Accordingly, if the step of coating the polymer material before cross-linking and curing that contains the aforementioned particles is omitted and the electrically insulative sheet is removed by etching or the like in the method described in Japanese Patent No. 5777477, the coin tablet-shaped movable electrode 120 having the structure shown in Figs. 1A and 1B can be obtained.

The reason for using the movable electrode 120 is as follows. Specifically, the particles 200, which are made of NiO as an electrically insulative topological antiferromagnetic substance, are formed using metallic Ni as its raw material. The metallic Ni used here is refined by the carbonyl method. Therefore, the microparticles of the metallic Ni used for the particles 200 have minute protrusions formed on their surfaces. Therefore, if metallic Ni refined by the carbonyl method is used for this purpose, favorable switching characteristics are obtained and excellent non-ohmic contact characteristics are developed. However, the minute protrusions are easily crushed by pressure or impact which are applied during use and as a result, there is a disadvantage that both of these characteristics are not sustainable. On the other hand, with rigid particles (e.g., particles 200) which are held in an elastomer such as the electrically insulative thin films 112 and 132, "soft, low-pressure contact" is achieved and thus, the minute protrusions are less likely to be crushed. As a result, the rigid particles held in an elastomer have an advantage that both of the aforementioned characteristics are maintained easily. Furthermore, when the rigid particles (particles 200) are brought into indirect contact with the elastomer (electrically insulative thin films 112 and 132) via the movable electrode 120, the stress applied to the elastomer (electrically insulative thin films 112 and 132) is dramatically reduced. For this reason, the electrical properties of the anisotropic electroconductive film, such as the single particle film 110 and the cluster film 130, are improved and as a result, an anisotropic electroconductive film having a small thickness and excellent electrical properties is obtained. The movable electrode 120 is used because of these advantages.

Next, the particle 200 used in the electroconductive connector 100 according to the first embodiment of the present invention will be described.

The particle 200 used in the electroconductive connector 100 according to the first embodiment that has the above-described structure is formed by nickel oxide (NiO) which is a substance that exhibits topological antiferromagnetic properties, and exhibits topological antiferromagnetic properties. However, the raw material of the particle 200 is metallic nickel (Ni), a substance that exhibits ferromagnetic properties. Generally, topological antiferromagnetic substances have the unique property of being insulators (electrically non-electroconductive) internally, but conductors (electrically electroconductive) on the surface. Furthermore, this property remains unchanged even after repeated aggregation and crushing of the substances. Here, "antiferromagnetic" refers to the magnetism of a substance in which adjacent spins are aligned in opposite directions and have no overall magnetic moment. In addition, antiferromagnetic substances (antiferromagnets) exhibit this property only at low temperatures below the Neel temperature. This also applies to the particle 200 exhibiting topological antiferromagnetic properties. Furthermore, since the particle 200 is formed by an aggregation of microparticles 202 (see Figs. 2A and 2B), the same is true for the microparticle 202.

The particle 200 (and the microparticles 202 that form it) is produced as follows. The anisotropic electrical conductivity and the quantum effects of the particle 200 (and the microparticles 202) are realized in the processes where the approximately spherical particles 200 (which are aggregates of the microparticles 202) shown in Fig. 2B are added, together with a binder, to an electrically insulative polymer material before cross-linking and curing which is prepared for the single particle film (first anisotropic electroconductive film) 110 or the cluster film (second anisotropic electroconductive film) 130, and then, the raw material thus obtained is formed into a sheet to form the electrically insulative thin film 112 or 132. The anisotropic electrical conductivity and the quantum effects thus realized in the particle 200 are then fixed (memorized) within the cross-linked and cured electrically insulative thin film 112 or 132.

In the first embodiment, as shown in Figs. 7 and 17, first, Ni ore is prepared as a raw material (see stage 1 in Fig. 7 and step S1 in Fig. 17). The Ni ore as the raw material contains voids, lattice defects, impurities, or the like, resulting in a low density. Specifically, the density is 1.7 to 3.5 g/cm³. Since the density of pure Ni crystals is 8.9 g/cm³, it is apparent that the density of the Ni ore is significantly low. Next, the Ni ore is refined using the well-known carbonyl method (a process in which impure metals are converted into volatile compounds, which are then thermally decomposed to revert to the metal, thereby purifying the metal), thereby producing approximately spherical microparticles 202 with diameters ranging from several tens to several hundreds of nanometers, as shown in Fig. 2A. Since the resulting microparticles 202 are oxidized during the processes of the carbonyl method, they contain oxygen (O). Therefore, the microparticles 202 are composed of NiO, not Ni. However, it is conjectured that the entire microparticle 202 is not oxidized, and that perhaps Ni remains inside, while the interface with the interior and the surface layer are oxidized to form NiO. In the following, for the purpose of simplifying the description, explanation will be carried out under the assumption that the (entirety of) microparticle 202 has been converted to NiO.

The surfaces of the microparticles 202 thus formed, which are made of NiO, have minute protrusions (unevenness). Microvoids, lattice defects, impurities, etc. (not shown) are also present inside the microparticles 202. These play an important role in the process of developing and establishing magnetic anisotropy in the microparticles 202. This will be discussed later.

Next, the metallic Ni microparticles 202 thus obtained are fired or sintered at an appropriate temperature in the range from 300 to 1200°C using a known powder metallurgy method to form aggregates (fired or sintered bodies) of the microparticles 202.

Then, the aggregates of the microparticles 202 thus obtained are crushed using a known milling method, granulated, and classified to obtain uniformized particles, resulting in approximately spherical particles 200 with diameters (median diameters) in the range from approximately 0.1 µm to approximately 10 µm (see Stage 2 in Fig. 7 and Step S2 in Fig. 17). The approximately spherical particles 200 obtained in this manner are aggregates of the microparticles 202 made of NiO and therefore, the particles 200 are also made of NiO.

The approximately spherical particles 200 obtained in this manner are in the state prior to the imparting of magnetic anisotropy and the exhibition of quantum effects. In a subsequent antiferromagnetic treatment process (described below), the particles 200 (and the microparticles 202 that form them) are imparted with magnetic anisotropy and the development and establishment of quantum effects are achieved (see Stage 3 in Fig. 7 and Steps S3-S4 in Fig. 17).

Since each particle 200 is formed by aggregating the microparticles 202, as shown in Fig. 2B, protrusions (unevenness) 204 resulting from the microparticles 202 are formed on the surface of each particle 200. Furthermore, the interior of each particle 200 contains defects (microvoids, lattice defects, impurities, etc.) resulting from the microparticles 202. The protrusions (unevenness) 204 and the defects of each particle 200 serve as paths for magnetic fluxes and spin currents (i.e., magnetic circuits).

As the material for the approximately spherical particles 200 with the magnetic anisotropy and the quantum effects, any substance that exhibits topological antiferromagnetic properties through post-processing such as heating and applying a magnetic field can be used. For example, NiO (nickel oxide), which is used in the electroconductive connector 100 according to the first embodiment, is particularly preferable because it has a Neel temperature of 525 K, which is above 0°C. However, MnO (manganese oxide, with a Neel temperature of 116 K) can also be preferably used.

Other than these, Cr₂O₃ (chromium oxide), Mn₃Ge, Mn₃Sn, MnS, MnTe, MnF₂, FeF₂, FeCl₂, FeO, CoCl₂, CoO, NiCl₂, NiO, and Cr can also be used. Needless to say, MnTe (307K), FeO (298K), CoO (291K), and Cr (308K), which have Neel temperatures of 0°C or higher, are preferred because their antiferromagnetic properties can be easily utilized.

In addition to the carbonyl method used in this first embodiment, other known methods for producing the raw material for the approximately spherical particles 200 before the antiferromagnetic treatment include the atomization method (a thin stream of molten metal or alloy is poured out of a small hole in the bottom of a crucible, and high-speed air, nitrogen, argon, water, etc. is sprayed onto the stream, causing the molten metal or alloy to disperse and rapidly cool and solidify, thereby producing powder of the metal or alloy) and the electrolysis method (electrolyzing the raw material, causing powder of the raw material to precipitate on a cathode). However, according to the experiments conducted by the inventors, the desired favorable results were obtained only in the case using the carbonyl method. Therefore, it is preferable to produce the approximately spherical particles 200 before the antiferromagnetic treatment using the carbonyl method.

Fig. 3A is a graph comparing the PRESS-ON load (when pressure is applied) for the electroconductive connector 100 using the particles 200 using metallic Ni produced by the carbonyl method and the atomization method in the experiment conducted by the inventors, Fig. 3B is a diagram showing an overview of the measurement probe used in the said experiment, and Fig. 3C is an external view of the measurement device used in the said experiment. In Fig. 3A, the load distribution when the electrical resistance falls below 30 Ω is shown, where the number (n) of the samples is 10.

As can be seen from Fig. 3A, the press-on load for the particles 200 using metallic Ni which is produced by the carbonyl method (carbonyl nickel) is significantly lower than that for the particles 200 using metallic Ni which is produced by the atomization method (atomized nickel). Specifically, the press-on load for the carbonyl nickel is significantly lower than (1/10) for the atomized nickel, which demonstrates a significant difference between the two. Converting the press-on load for the carbonyl nickel to that for an electrode with a diameter of 0.04 mm corresponds to 0.013 times the press-on load for an electrode with a diameter of 0.35 mm, which indicates that the press-on load is in the mg range. This means that the electroconductive connector 100 according to the first embodiment, in which the carbonyl nickel is used, requires only a very small contact pressure (contact force) with the terminals 304 on the wafer 300.

The inventors' opinion is as follows: Specifically, the reason why such the difference as above occurs in the press-on load is that the microparticles 202 formed using the carbonyl nickel have the minute protrusions (irregularities) on their surfaces, and that more defects (microvoids, strain, lattice defects, impurities, etc.) than the microparticles produced by methods other than the carbonyl method, such as the atomization method and the electrolysis method, are contained in the interiors of the microparticles 202 formed using the carbonyl nickel.

In other words, in the microparticles 202 that form the particle 200 in which the magnetic anisotropy and the quantum effects have been developed and fixed, the surfaces and interfaces of the microparticles 202 are NiO and as a result, a topologically superconducting state is created, while the interiors of the microparticles 202 are kept in the ferromagnetic state of Ni. Therefore, a part of the magnetic flux from the external magnetic field applied during the antiferromagnetic treatment enters the surfaces and the interfaces of the microparticles 202 which are in a topologically superconducting state. Since the aforementioned protrusions (irregularities) and the aforementioned defects provide escape routes for the magnetic flux that has entered the surfaces and the interfaces of the microparticles 202, the said magnetic flux is prevented from moving away from the said protrusions (irregularities) and the said defects. As a result, the said magnetic flux is pinned to the escape routes, which develops the magnetic anisotropy in the microparticles 202. These explanations are based on the inventors' conjecture.

Due to the aforementioned magnetic anisotropy, the easy direction of magnetization of the microparticles 202 (and the particles 200) is rotated toward the direction of the said magnetic flux and are fixed in the same direction. Therefore, the easy direction of magnetization of the microparticles 202 (and the particles 200) coincides with the direction of the said magnetic flux.

Furthermore, it is conjectured that in addition to the development and fixation of the magnetic anisotropy described above, the quantum effects (skyrmion generation, tunneling magnetoresistance effect, electrical current-spin current conversion, etc.) are developed and fixed by the antiferromagnetic treatment of the microparticles 202 (and the particles 200), and that these quantum effects cause a spin current with a nearly zero spin current resistance, or an electrical current with an extremely low electrical current resistance, to flow in the conduction portion 114 of the single particle film 110 or the conduction portion 134 of the cluster film 130. It is also conjectured that these are the cause of the above-mentioned difference in PRESS-ON load. The said quantum effects and their functions will be described in detail later.

Next, with reference to Figs. 4 and 8, a method of forming the single particle film (first anisotropic electroconductive film) 110 and the cluster film (second anisotropic electroconductive film) 130 used in the electroconductive connector 100 according to the first embodiment will be explained. At the same time as this, the development and the fixation of the magnetic anisotropy and the quantum effects of the granular particles 202b (and the particles 200a) will be also mentioned.

As shown in Fig. 4A, first, the approximately spherical particles 200 with a diameter (median diameter) ranging from approximately 0.1 µm to approximately 10 µm are added, together with a binder, to an uncured electrically insulative polymer material which is prepared for the electrically insulative thin film 112 that will form the single particle film (first anisotropic electroconductive film) 110, resulting in a raw material (see step S3 in Fig. 17). The particles 200 and the microparticles 202 that form them are both before the above-mentioned magnetic anisotropy is imparted and the above-mentioned quantum effects are exhibited, and therefore, they do not have the magnetic anisotropy and the quantum effects.

Next, a sheet-like cavity (not shown) formed in a mold 500 is evacuated, and the aforementioned raw material is injected into the cavity. The mold 500 is equipped with a magnetic field generator 520, whose coil 522 generates a magnetic field that passes through its yoke 524. In this way, it is configured that a magnetic field is applied to the cavity in the mold 500. Then, a magnetic field is generated by the magnetic field generator 520, and this magnetic field is applied to the raw material injected in the cavity via the mold 500. At the same time, the raw material in the cavity is heated to a predetermined temperature (e.g., 100°C) using a heating device (not shown). After a predetermined time has passed, both the application of the magnetic field and the heating are stopped, and then, the raw material is left at room temperature for another predetermined time, thereby crosslinking and hardening the raw material. In this way, the electrically insulative thin film 112 (i.e., the single particle film 110) in which the particles 200 are dispersed is obtained.

Due to the application of the magnetic field and the heat, the particles 200 (and the microparticles 202 that form them) in the raw material exhibit the magnetic anisotropy and the quantum effects. Then, by leaving the raw material at room temperature in the state where the application of the magnetic field and the heat are both stopped, the magnetic anisotropy and the quantum effects that have exhibited in the particles 200 (and the microparticles 202 that form them) in the raw material are fixed (see steps S4 and S5 in Fig. 17).

Furthermore, the particles 200 in the raw material, which are made of NiO, and the microparticles 202 that form them are hardly oxidized by the heating. This is because much of the metallic Ni as the raw material has been oxidized and converted to nickel oxide (NiO) during refining using the carbonyl method. However, it is conjectured that not all of the metallic Ni has been converted to nickel oxide (NiO) at this time, and that some of the Ni existing in the microparticles 202 has been left. Therefore, it seems that parts which are kept in the ferromagnetic state exist in the microparticles 202.

The strength of the magnetic field and the heating temperature are set within respective ranges such that the particles 200 and the microparticles 202 that form them in the raw material exhibit the magnetic anisotropy and the quantum effects as desired.

The method for forming the cluster film (second anisotropic electroconductive film) 130 is the same as the aforementioned method for forming the single particle film 110, except that the separated particle 200 forming a single particle layer is replaced with a cluster 210 of the two (or three or more) overlapping particles 200. Therefore, the method for forming the electrically insulative thin film 112 (the method for forming the single particle film 110) shown in Figs. 4A and 4B is also applied to the method for forming the electrically insulative thin film 132 (the method for forming the cluster film 130) shown in Figs. 4A and 4C. Accordingly, a description about the method for forming the electrically insulative thin film 132 will be omitted.

The method for forming the electrically insulative thin film 112 (the method for forming the single particle film 110) shown in Figs. 4A and 4B and the method for forming the electrically insulative thin film 132 (the method for forming the cluster film 130) shown in Figs. 4A and 4C can also be performed using a film formation apparatus such as that shown in Fig. 8A.

The film formation apparatus shown in Fig. 8A is configured to pour the raw material into a gap formed by upper and lower supporting members 540 and 542, which are arranged facing each other, to form the raw material into a sheet. The upper and lower supporting members 540 and 542 are rotationally driven by rollers 530 and 532, respectively, and translated in the same direction (toward the right in Fig. 8). The raw material poured into the gap is sandwiched between the upper and lower supporting members 540 and 542 and translated on a horizontal plane in the sandwiched state, forming the raw material into a sheet during the movement. During this process, a weak magnetic field generated by the coil 522 of the magnetic field generator 520 is applied to the raw material. The raw material is also heated to a predetermined temperature (e.g., 100°C) by the heating device (not shown). Due to the application of the magnetic field and the heating (the antiferromagnetic treatment), the particles 200 and the microparticles 202 that form them in the raw material exhibit the magnetic anisotropy and the quantum effects. This is the same as the film formation apparatus shown in Fig. 4A.

As shown in the right diagram of Fig. 8, by leaving the sheet-shaped raw material at room temperature in the state where the application of the magnetic field and the heat are stopped, the raw material is cross-linked and hardened in the same state. Due to this operation, the magnetic anisotropy and the quantum effects developed in the particles 200 and the microparticles 202 that form them in the raw material are fixed. In this way, the electrically insulative thin film 112 or 132 (i.e., the single particle film 110 or the cluster film 130) in which the particles 200 are dispersed is obtained. This is also the same as the film formation apparatus shown in Fig. 4A.

As mentioned previously, the particles 200 and the microparticles 202 that form them, which are made of metallic Ni, dispersed in the raw material are not oxidized by the heating. The particles 200 and the microparticles 202 that form them in the raw material, which have the magnetic anisotropy and the quantum effects, are formed by nickel oxide (NiO) rather than metallic Ni. However, it is conjectured that not all of the metallic Ni is converted to nickel oxide (NiO) and some of the Ni existing in the microparticles 202 are left. Therefore, it seems that parts which are kept in the ferromagnetic state exist in the microparticles 202. This is also the same as the film formation apparatus shown in Fig. 4A. It goes without saying that the strength of the aforementioned magnetic field and the heating temperature are also set within respective ranges in which the particles 200 (and the microparticles 202 that form them) in the raw material exhibit the magnetic anisotropy and the quantum effects, which is also the same as above.

Next, the magnetic field applied to the cavity formed in the mold 500 will be described with reference to Figs. 10 and 11, as well as Figs. 4A and 4C.

Researches by the inventors have revealed that the aforementioned magnetic field is preferably a parallel magnetic field, but that there is a preferred range for its strength. This preferred range is from 10² to 10³ gauss. In other words, when the lower limit of this range is defined Hc1 and the upper limit thereof is defined as Hc2, the lower limit Hc1 is 10² (=100) gauss and the upper limit Hc2 is 10³ (=100) gauss. Figs. 4B and 4C show that a parallel magnetic field having a strength within this preferred range (i.e., between the lower limit Hc1 and the upper limit Hc2) is applied as the aforementioned magnetic field.

As clearly shown in Fig. 10, it has been found that in order to develop and establish the magnetic anisotropy of the particles 200 (and the microparticles 202 that form them) in the raw material, the strength of the aforementioned magnetic field is preferably set to the lower limit Hc1 of the preferred range, i.e., 10² (=100) gauss. In this case, it seems to the inventors that all of the magnetic moments (minute magnets) of the granular particles 202b in the raw material are aligned to the direction of the magnetic flux of the said magnetic field, resulting in the highest degree of magnetic anisotropy being exhibited in the particles 200 (and the microparticles 202) in the raw material. It is the single-particle film 110 in which only the separated particles 200 exist in the electrically insulative thin film 112 that the strength of the said magnetic field is set at the lower limit Hc1 of the preferred range.

Therefore, it seems that the strength of virtual magnetic fields which are generated in the particles 200 (and the microparticles 202) in the raw material is at its highest level, and as a result, the development of the quantum effects (skyrmion generation, tunneling magnetoresistance, electrical current-spin current conversion, etc.) developed in the particles 200 (and the microparticles 202) in the raw material can be maximized. In this case, as shown in Fig. 11, the spin current resistance Rs is approximately zero, which makes it possible to realize electrical conduction with nearly zero electrical resistance in the conduction path 114 of the single particle film 110.

It seems that if the strength of the aforementioned magnetic field applied to the particles 200 (and the microparticles 202) in the raw material is set at the upper limit Hc2 of the aforementioned preferred range, i.e., 10³ (=1000) gauss, the magnetic anisotropy of the particles 200 (and the microparticles 202 that form them) in the raw material is disrupted. This means that not all of the magnetic moments (minute magnets) of the microparticles 202 are aligned to the direction of the magnetic flux of the said magnetic field, and some of the magnetic moments (minute magnets) are deviated from the direction of the magnetic flux of the said magnetic field. As a result, it seems that the level of the magnetic anisotropy is reduced compared with the case where the strength of the said magnetic field is set at the lower limit Hc1 of the preferred range. It is the cluster film 130 in which only the isolated particle clusters 210 exist in the electrically insulative thin film 132 that the strength of the said magnetic field is set at the upper limit Hc2 of the preferred range.

Therefore, it seems that the strength of the virtual magnetic fields generated in the particles 200 (and the microparticles 202) in the raw material is reduced from the maximum level described above, and as a result, the level of the quantum effects developed in the particles 200 (and the microparticles 202) in the raw material is also reduced from the maximum level described above. In this case, as shown in Fig. 11, the spin current resistance Rs is approximately zero, but the electrical current resistance Re is a finite value exceeding zero and therefore, the electrical resistance, which is the sum of the spin current resistance Rs and the electrical current resistance Re, also is a finite value exceeding zero. Accordingly, it is possible to realize electrical conduction with the electrical resistance suppressed to a low value exceeding zero in the conduction path 114 of the cluster film 130.

It seems that if the strength of the aforementioned magnetic field applied to the particles 200 (and the microparticles 202) in the raw material is set above the upper limit Hc2 of the preferred range, i.e., 10³ (=1000) gauss, the magnetic anisotropy of the particles 200 (and the microparticles 202) in the raw material will be completely destroyed, and the magnetization of the particles 200 (and the microparticles 202) will be saturated. This means that all of the magnetic moments (minute magnets) of the microparticles 202 are not aligned to the direction of the magnetic flux of the said magnetic field. As a result, it seems that the level of the magnetic anisotropy is significantly reduced compared with the case where the strength of the said magnetic field is set at the lower limit Hc1 of the preferred range, reaching a level that can be considered nonexistent. It will be a film (not shown) in which only non-separated particle clusters 210 exist in the electrically insulative thin film that the strength of the said magnetic field is set at a value above the upper limit Hc2 of the preferred range.

Therefore, it seems that the strength of the virtual magnetic fields generated in the particles 200 (and the microparticles 202) in the raw material is significantly reduced from the maximum level described above and as a result, the level of the quantum effects developed in the particles 200 (and the microparticles 202) in the raw material is also significantly reduced from the maximum level described above to the extent where it can be considered nonexistent. In this case, as shown in Fig. 11, the electrical resistance is increased furthermore, which makes it impossible to achieve electrical conduction with an electrical resistance suppressed to a low value.

Next, the relationships between the thicknesses of the electrically insulative thin films 112 and 132 of the single particle film 110 and the cluster film 130, and the size (diameter) of the particles 200.

The single particle film 110 has the structure in which the separated particles 200 are dispersed and arranged in the electrically insulative thin film 112 so as to form a single layer in the in-plane direction of the electrically insulative thin film 112. To realize this structure, the thickness of the electrically insulative thin film 112 is set at a value less than twice the median diameter of the particles 200. For this reason, the particles 200 (and the microparticles 202) in the raw material are prevented from being aggregated in the thickness direction of the electrically insulative thin film 112 during the formation of the electrically insulative thin film 112 and at the same time, the separated situation of the particles 200 is maintained. As a result, the particles 200 are reliably dispersed and arranged as a single particle layer within the electrically insulative thin film 112 during the film formation process, as shown in Fig. 1B. This reliably prevents the single particle film 110 (the electrically insulative thin film 112) thus formed from being electrically conductive in its in-plane direction, in other words, reliably prevents adjacent two of the conduction portions 114 from being electrically conductive.

Furthermore, as shown in Fig. 4B, due to the magnetic field applied during the film formation process, the easy direction of magnetization of the particles 200 (and the microparticles 202) in the raw material is aligned to the direction of the magnetic flux of the magnetic field, i.e., the thickness direction of the electrically insulative thin film 112, and as a result, the desired magnetic anisotropy are developed in the particles 200 (and the microparticles 202) in the raw material.

The cluster film 130 has the structure in which the particles 200 dispersed in the electrically insulative thin film 132 are aggregated in the thickness direction of the electrically insulative thin film 132 to form rows. To realize this, the thickness of the electrically insulative thin film 132 is set at a value equal to or greater than twice the median diameter of the particles 200. For this reason, during the formation of the electrically insulative thin film 132, the clusters containing two (or three or more) of the particles 200 aggregated in the thickness direction of the electrically insulative thin film 132 are reliably dispersed and arranged as a single cluster layer in the electrically insulative thin film 132 during the film formation, as shown in Fig. 1B, in the same manner as the separated particles 200 arranged in the electrically insulative thin film 112 of the single particle film 110. This reliably prevents the cluster film 130 (the electrically insulative thin film 132) thus formed from being electrically conductive in its in-plane direction, in other words, reliably prevents adjacent two of the conduction portions 134 from being electrically conductive.

Furthermore, as shown in Fig. 4C, due to the magnetic field applied during film formation process, the magnetic moments (minute magnets) of the particles 200 (and the microparticles 202) in the raw material are aligned to the direction of the magnetic flux of the magnetic field, i.e., the thickness direction of the electrically insulative thin film 132, and as a result, the desired magnetic anisotropy are developed in the particles 200 (and the microparticles 202) in the raw material.

Fig. 2C shows an electron microscope photograph of a specific example of the particle 200 which was actually produced by the inventors. The particle 200 shown in Fig. 2C has a diameter of 2 to 3 µm, and it can be seen that protrusions (unevenness) 204 are formed on the surface of the particle 200. The height difference among the protrusions (unevenness) 204 is within the range of approximately 10 to approximately 100 nm.

Subsequently, the results of a comparative test of various performance characteristics will be explained below with reference to Fig. 5. The test was conducted on the probe produced using the electroconductive connector 100 and the probes of Comparative Examples 1 and 2 in order to evaluate the performance of the electroconductive connector 100 according to the first embodiment of the present invention.

The probe of Comparative Example 1 used in the above test uses a metal terminal as the electroconductive connector. The metal terminal is made of spring-elastic tungsten or phosphor bronze, and is formed by a metal wire (bending wire) that has been given a curvature to make it easily bendable.

The probe of Comparative Example 2 used in the above test uses PCR (pressurized electroconductive rubber). The PCR has been formed by dispersing gold- or silver-plated nickel particles in a silicone rubber sheet. The plated nickel particles were aggregated and magnetized by applying a strong magnetic field exceeding the upper limit Hc2 of the aforementioned preferred range for the strength of the magnetic field, i.e., 10³ (=1000) gauss, during the crosslinking and curing process of the sheet. This was intended to suppress an increase in the electrical resistance of the PCR.

Regarding the electrical resistance shown in Fig. 5 which shows the results of the above test, the electrical current resistance of the metal material used in the metal probe was observed in the metal probe of Comparative Example 1. An electrical current resistance lower than that of the metal probe of Comparative Example 1 was observed in the PCR of Comparative Example 2. In contrast, in the electroconductive connector 100 according to the present invention, almost no electrical current resistance existed and a spin current resistance of approximately 0 mΩ was observed. This means that the electroconductive connector 100 has a low resistance equivalent to that of a superconductor; therefore, it is conjected that the electroconductive connector 100 has electrical conductivity that utilizes electrical current-spin current conversion based on the aforementioned quantum effects.

The contact resistance was not measured in Comparative Examples 1 and 2. However, the fact that the electroconductive connector 100 according to the present invention has an electrical resistance of 0 mΩ means that the contact resistance is also 0 mΩ. In the electroconductive connector 100, even when a high electrical current was tried (a continuous electrical current was passed for 30 seconds), no heat generation was observed from the connector 100 although the measurement wires used therefor were heated up.

The contact force in Fig. 5 means the pressure required to pass an electrical current. The metal probe of Comparative Example 1 had a contact force of 10 g/pin, and the PCR of Comparative Example 2 had a contact force of 1 to 10 g/pin. However, the electroconductive connector 100 of the present invention had a contact force of 1 to 10 mg/pin. This means that the electroconductive connector 100 of the present invention can achieve electrical conductivity even when the load (contact force) applied to each pin is significantly lower than those of Comparative Examples 1 and 2. It is conjected that this is because a spin current flows through a tunnel barrier in the electroconductive connector 100. In other words, it is conjected that stable contact is achieved by utilizing a stable tunnel barrier (approximately 1 to 20 nm in thickness) such as an oxide film which is present on the surface of the contact object.

Regarding the contact stability (MTBF; mean time between failures) in Fig. 5, Comparative Example 1 was 10⁴ (10,000) times or less, Comparative Example 2 was 10⁴ to 10⁸ (10,000 to 1,000,000) times or less, while the conductive connector 100 according to the present invention was 10⁸ (100,000,000) times or more. Furthermore, regarding the maintaining contact stability, scrubbing (scratching the surface to remove oxide films, etc.), and washing, cleaning, etc. were required to remove tunnel barriers that inhibit the contact for an electrical current in Comparative Example 1. Scrubbing is not necessary but cleaning was necessary in Comparative Example 2. Neither scrubbing nor cleaning was required in the electroconductive connector 100 of the present invention.

Regarding the miniaturization in Fig. 5, in Comparative Example 1, the size was approximately 80 µm due to manufacturing reasons. In Comparative Example 2, the size was approximately 200 µm due to the limitations of clustering of the PCR particles (aggregated to cause lateral electrical conduction). In contrast, in the electroconductive connector 100 according to the present invention, the size was able to be miniaturized to a level of approximately 0.1 to approximately 10 µm, which is equal to the size of the particles 200, for the single particle film 110.

Moreover, regarding the upper limit of the pin count that can be tested simultaneously in Fig. 5 was, at most, 10k (ten thousand) for the metal probe of Comparative Example 1 due to contact stability, while the electroconductive connector 100 according to the present invention was capable of simultaneously contacting 1000k (one million) terminals. This is presumably due to the fact that the tunneling effect can be stably maintained by preserving the tunnel barrier nondestructively because the contact force per pin is significantly lowered, and that the electroconductive connector 100 is structured as the sheet stacking type that allows miniaturization in the electroconductive connector 100. However, it seems that the upper limit of the pin count varies depending on the MTBF in the electroconductive connector 100.

### (Operation of electroconductive connector 100 according to first embodiment of present Invention)

Next, the operation of the electroconductive connector 100 having the above-described structure will be described.

As is clear from the above explanation, which was made with reference to Fig. 5 showing the results of the performance comparison test, the electroconductive connector 100 according to the first embodiment of the present invention has such a low electrical resistance and a contact resistance that they exhibit 0 mΩ. The structure and conditions for achieving this will be explained below, but please note that some of the explanations shown below are based on the inventors' own speculations (which include matters that are difficult to confirm).

With the electroconductive connector 100 having such the structure as described above, the conduction portions 114 of the single particle film (first anisotropic electroconductive film) 110 and the conduction portions 134 of the cluster film (second anisotropic electroconductive film) 130 are formed by the particles 200 (and the microparticles 202 that form them). Therefore, the first reason why the electrical resistance and the contact resistance are as low as to be nearly 0 mΩ is that, due to the magnetic anisotropy and the quantum effects of the particles 200 (and the microparticles 202) made of NiO that exhibits topological antiferromagnetic properties, the surface and the interface of each of the particles 200 that form the conduction portions 114 and 134 are in a topological superconducting state, as shown in the right diagram in Fig. 9 and consequently, a spin current and an electrical current flow through the said surface and the said interface, resulting in that the electrical resistance (which is expressed as the sum of the electrical current resistance and the spin current resistance) of each of the conduction portions 114 and 134 will be equal to zero.

The second reason why the electrical resistance and the contact resistance are as low as to be nearly 0 mΩ is that since the conduction portions 114 of the single particle film (first anisotropic electroconductive film) 110 and the conduction portions 134 of the cluster film (second anisotropic electroconductive film) 130 are formed by the particles 200, (a) a plurality of spin current path candidates 606 that interconnect the south pole region 604 and the north pole region 602, which are respectively present at the ends of the easy direction of magnetization of the particle 200, are formed, (b) tunnel magnetoresistance effect occurs in the south pole region 604 and the north pole region 602 of the particle 200, and (c) electrical current-spin current conversion occurs in the south pole region 604 and the north pole region 602 of the particle 200, within each of the conduction portions 114 and 134, due to the magnetic anisotropy and the quantum effects of the particles 200 (and the microparticles 202), as shown in Fig. 14. Because of these three factors, as shown in Fig. 13, a "spin current" flows between the south pole region 604 and the north pole region 602 of the particle 200 made of NiO, which is an insulator, and an "electrical current" flows in a site existing outside the south pole region 604 and the north pole region 602, and furthermore, an electrical current and a spin current can be mutually converted in the south pole region 604 and the north pole region 602, thereby achieving electrical conduction within each of the conduction portions 114 and 134.

As shown in Fig. 14, skyrmions are generated in a concentrated manner in the south pole region 604 and the north pole region 602 of the particle 200. That is, a skyrmion-concentrated region or regions is/are formed in the south pole region 604 and the north pole region 602, respectively. Due to the function of the skyrmions present in the skyrmion-concentrated region(s), "tunnel magnetoresistance effect" and "electrical current-spin current conversion" are caused in the south pole region 604 and the north pole region 602.

Here, a skyrmion is a topological vortex-like magnetic structure formed by electron spins in a solid (magnetic material). The central spin and the peripheral spin of a skyrmion are antiparallel, and the spins between them are arranged in a vortex shape while slightly changing their directions. The diameter of the vortex is tens to hundreds of nanometers. When a skyrmion is generated, the magnetic flux density at the location of generation is amplified tens of thousands of times, thereby significantly increasing the strength of the magnetic field at the said location of generation. For this reason, the strength of the magnetic field in the skyrmion-concentrated region is caused to be extremely high, which maximizes the aforementioned quantum effects. These are based on the inventors' conjecture. In addition, since each skyrmion can be thought of as a tiny magnet, a repulsive force is applied between adjacent skyrmions. Therefore, as shown in Fig. 14, spin current path candidates 606, each of which is formed by skyrmions, is generated in a spherically bulging shape between the south pole region 604 and the north pole region 602.

Furthermore, skyrmions are generated along the magnetic flux of the external magnetic field that penetrates into the particle 200 and that is pinned so as to interconnect the south pole region 604 and the north pole region 602 of the particle 200. Due to the action of these skyrmions, conduction paths for spin currents are formed along the said magnetic flux that interconnect the south pole region 604 and the north pole region 602.

Due to the above-mentioned "tunnel magnetoresistance effect", a spin current penetrates through the electrically insulative film, such as an oxide film, of the particle 200 without destroying the said electrically insulative film, thereby achieving electrical conduction in each of the conduction portions 114 and 134, as shown in Fig. 12A.

Furthermore, due to the above-mentioned "electrical current-spin current conversion", a "spin current" that causes electrical conduction between the south pole region 604 and the north pole region 602 by way of a spin current conduction path that interconnects the south pole region 604 and the north pole region 602 of the particle 200 and an "electrical current" that causes electrical conduction in the other site or sites can be converted.

In this way, as shown in Fig. 13, electrical conduction can be realized in each of the conduction portions 114 and 134, which is formed by the particle or particles 200, while keeping the electrical resistance and the contact resistance as low as to be nearly 0 mΩ.

With the electroconductive connector 100, as described above, a topological superconducting state occurs on the surfaces and the interfaces of the particles 200 that forms the conduction portions 114 and 134. Furthermore, the conduction portions 114 and 134 are made electrically conductive by the reasons that (a) conduction paths for spin currents that interconnect the south pole region 604 and the north pole region 602, which are respectively present at the ends of the easy direction of magnetization of the particle 200, are formed, (b) tunnel magnetoresistance effect occurs in the south pole region 604 and the north pole region 602 of the particle 200, and (c) electrical current-spin current conversion occurs in the south pole region 604 and the north pole region 602 of the particle 200. Accordingly, even with a minute contact point with a diameter of 40 µm, and even when a high electrical current of 3 A was passed for several tens of seconds three times, no change occurred in the heat generation state. This is presumably because these four points were realized.

In addition, as shown in Fig. 12B and Fig. 15A and 15B, spin currents have a characteristic named as "exclusive spin current conduction path switching" in which the one with the lowest spin current resistance is instantly found and switched thereto from among a plurality of spin current path candidates 606 present between a pair of electrodes. It is conjectured that the electrical resistance of each of the conduction portions 114 and 134 tends to be lowered furthermore due to such the characteristic as above when it is intended to achieve electrical conduction in the conduction portions 114 and 134 by utilizing the aforementioned magnetic anisotropy and the aforementioned quantum effects of the particles 200.

It is understood that the paths of magnetic flux of an external magnetic field, which are present inside the particles 200, correspond to the spin current conduction path candidates 606 used in the "exclusive spin current conduction path switching". Because the particle 200 is an aggregation of the microparticles 202, the particle 200 has a large quantity of interfaces (defects and surfaces) between the microparticles 202, and therefore, these interfaces will serve as the spin current paths. Defects (microvoids, strains (lattice defects), impurities) present inside the microparticle 202, which have been caused by the carbonyl process, gaps between the microparticles 202 present inside the particle 200, and interfaces (surfaces) between the particle 200 and the microparticles 202 also will serve as the spin current path candidates 606. One of these many spin current path candidates 606 is selected depending on the type of an applied electrical signal, such as direct current or high frequency, and a spin current flows through the candidate 606 thus selected. Needless to say, as can be seen from Fig. 11, an electrical current may also flows through the spin current path candidate 606 along with the spin current.

Fig. 16 shows the relationship between the size (diameter) of the conduction portions 114 and 134 of the anisotropic electroconductive film (single particle film, cluster film) used in the electroconductive connector 100 according to the first embodiment and the generation situation of the spin current path candidates 606 formed in the conduction portions 114 and 134.

As seen from Fig. 16, due to the aforementioned characteristic of the "exclusive spin current conduction path switching", a spin current flowing through a voltage-driven circuit is automatically switched instantaneously to the path with the lowest spin current resistance (which is nearly 0 Ω). Therefore, it is clear that the electroconductive connector 100 having such the characteristic as above facilitates further miniaturization of the connector 100.

The specific dimensions of each part of the electroconductive connector 100 having the above-mentioned structure are determined so as to match the arrangement of the terminals 304 on the wafer 300 and that of the electrodes 404 on the test head 400.

Incidentally, the vortex-like structure formed when a magnetic field enters a type-II superconductor is called a "superconducting vortex." It has recently been revealed that this "superconducting vortex" coexists with a "skyrmion" which is a topological spin structure that appears in magnetic materials. In other words, as shown in Fig. 9, it has been observed that in the case where the interface between the surface layer of the microparticle 202 and the interior thereof is in a topological superconducting state, skyrmions are present in the superconducting surface layer and at the superconducting interface, which means that the superconducting state and skyrmions coexist together. This demonstrates that the aforementioned explanation given for the operation of the electroconductive connector 100 is scientifically valid.

Moreover, as shown in Fig. 14, since skyrmions are generated in a concentrated manner in the south pole region 604 and the north pole region 602 of the particle 200, the density of the spin current path candidates 606 is also concentrated in these two regions 604, 602. For this reason, the density of the spin current path candidates 606 in the south pole region 604 and the north pole region 602 is estimated to be 10⁶ (100,000) times the density of the spin current path candidates 606 near the central nucleus of the particle 200. This is because the area of the cross section near the central nucleus of the particle 200 is interpreted to be 10⁶ (100,000) times the area of each of the south pole region 604 and the north pole region 602. In this way, the spin current path candidates 606 are present at such a high density as above in each of the south pole region 604 and the north pole region 602. In addition to this, the protrusions (irregularities) 204 that contribute to the generation of the spin current path candidates 606 are present on the surfaces of the approximately spherical particle 200. Accordingly, it is conjectured that the selection efficiency of the spin current path candidates 606 when a voltage is applied is improved, and the MTBF during repeated contact is also maximized (MTBF ≧10⁸).

### (Electroconductive connector 100A according to second embodiment of present invention)

Fig. 19 is a schematic cross-sectional view showing the structure of an electroconductive connector 100A according to a second embodiment of the present invention.

As shown in Fig. 19, the electroconductive connector 100A uses four anisotropic electroconductive films which are used in the electroconductive connector 100 according to the first embodiment described above. Specifically, the single particle film 110 is disposed as a bottom layer (the first layer), a layer of the movable electrodes 210 is disposed on the bottom layer as the second layer, and the cluster film 130 is disposed further on that as the third layer. The structure so far is the same as that of the electroconductive connector 100 according to the first embodiment described above.

On the cluster film 130 as the third layer, a layer of the movable electrodes 210 is disposed as the fourth layer. The cluster film 130 as the fifth layer is disposed on the fourth layer, a layer of the movable electrodes 210 as the sixth layer is disposed on the fifth layer, and the cluster film 130 as the seventh layer is disposed on the sixth layer.

In the electroconductive connector 100A according to the second embodiment, since four of the anisotropic electroconductive films 110 and 130 in total are used, there is an advantage that the amount of displacement of the anisotropic electroconductive film in each layer can be reduced furthermore compared with the electroconductive connector 100 according to the first embodiment which uses two of the anisotropic electroconductive films in total are used. As a result, the contact pressures generated on the anisotropic electroconductive film of each layer and the terminals 304 and electrodes 404 can be lowered and at the same time, the durability of the electroconductive connector 100 can be increased.

In addition, structures in which an electrically insulative layer is provided on the surface of an electroconductive particle in an anisotropic electroconductive film have been proposed. For example, the aforementioned Patent Literature 2 (Japanese Patent Publication No. 5476221) describes a structure in which a nickel electroconductive layer is provided on the surface of a base material particle (resin), and a nickel oxide or nickel hydroxide coating is provided on the outer surface of the nickel electroconductive layer. Furthermore, the aforementioned Patent Literature 3 (Japanese Patent Application Publication No 2021-064591) and Patent Literature 4 (Japanese Patent Application Publication No 2022-041178) also propose a coated particle formed by coating an electroconductive particle with an electrically insulative layer.

However, in these literatures, it is assumed that the electroconductive layers are electrically connected to each other by applying a high load to the anisotropic electroconductive film to break the oxide layer, thereby achieving electrical conductivity between the said electroconductive layers (in other words, electrical conductivity using electronics is intended). Such the conventional conduction methods as proposed here cannot cause stable spin current-electrical current conversion. Unless the electroconductive layers are configured to contact each other with a low load, it is impossible to achieve the coexistence of highly efficient spin current-electrical current conversion and topological superconductivity as in the present invention. However, with the conventional structures, it was not possible to simultaneously achieve electrical conductivity between a plurality of electrodes without applying a high load, and therefore, the method of breaking the oxide film did not pose any problems.

In contrast, in the structure of the electroconductive connectors 100 and 100A according to the present invention, the single particle film 110 and the cluster film 130 have flexibility in the thickness direction thereof, and the cluster film 130 has elasticity in the thickness direction thereof, which make it possible to absorb minute irregularities existing on the terminals 304 on the wafer 300 and/or the electrodes 404 of the test head 400. Furthermore, since the movable electrodes 120 (coin tablet type) do not have a supporting film (retaining film), there is nothing to obstruct the movement of the movable electrodes 120 in the thickness direction thereof. Because of these factors, contact stability at low loads is improved. Moreover, the particles 200 exhibiting topological antiferromagnetic properties come into contact with the circuits 302 on the wafer 300 and/or the electrodes 404 of the test head 400 with extremely small areas under application of a low load, and therefore, probes for semiconductor testing apparatus can be further miniaturized.

### (Modifications)

Finally, possible modifications of the first and second embodiments described above are described.

In the first and second embodiments described above, the particles 200 made of an electrically insulative topological antiferromagnetic substance are manufactured using NiO which is obtained by oxidizing metallic Ni refined using the carbonyl method. This NiO may be single-crystal NiO alone, or a polycrystalline mixture of Ni and NiOx. Manganese (Mn) can also be used instead of Ni. In this case also, similar to the case of using NiO, the particles 200 can be manufactured using MnO obtained by oxidizing metallic Mn refined using the carbonyl method. There are several types of MnO with different oxidation numbers, and any of them is acceptable. This MnO may be single-crystal MnO alone, or a polycrystalline mixture of Mn and MnOx.

In addition to NiO and MnO, Cr₂Oₐ, Mn₃Ge, Mn₃Sn, MnS, MnTe, MnF₂, FeF₂, FeCl₂, FeO, CoCl₂, CoO, NiCl₂, NiO, and Cr can be used.

While the preferred embodiments of the present invention have been described above with reference to the accompanying drawings, it goes without saying that the present invention is not limited to these. Those skilled in the art will clearly be able to conceive of various modifications and alterations within the scope of the claims, and it will be understood that these modifications and alterations naturally fall within the technical scope of the present invention.

### INDUSTRIAL APPLICABILITY

The present invention is preferably applicable for use in situations where collective, electrical connection to a large number of electrodes (e.g., hundreds to tens of thousands) of a test object or objects is necessary (e.g., wafer probes provided in semiconductor testing apparatuses used in wafer testing).

### DESCRIPTION OF REFERENCE SIGNS

- 100, 100A: electroconductive connector
- 110: single particle film
- 112: electrically insulative thin film
- 114: conduction portion
- 120: movable electrode
- 130: cluster film
- 132: electrically insulative thin film
- 134: conduction portion
- 200: particle
- 202: microparticle
- 204: protrusion (unevenness) on surface of particle
- 300: wafer
- 302: circuit
- 304: terminal
- 400: test head
- 404: electrode
- 500: mold
- 520: magnetic field generator
- 522: coil
- 530, 532: roller
- 540: upper supporting member
- 542: lower supporting member
- 602: north pole region of particle
- 604: south pole region of particle
- 606: spin current path candidate

## Claims

1. An anisotropic electroconductive film comprising:
an electrically insulative thin film made of an elastic electrically insulative polymer material; and
approximately spherical particles, which are made of a substance exhibiting topological antiferromagnetic properties, dispersed in the electrically insulative thin film;
wherein the particles form conduction portions that are arranged apart from each other in an in-plane direction of the electrically insulative thin film so as not to generate electrical conduction in the in-plane direction and that allow electrical conduction in a thickness direction of the electrically insulative thin film;
each of the particles has magnetic anisotropy, and its easy direction of magnetization is oriented in the thickness direction of the electrically insulative thin film;
each of the particles has a south pole region and a north pole region that are respectively formed at two ends thereof in a direction along the easy direction of magnetization, each of the south pole region and the north pole region being subject to concentration of magnetic flux of virtual magnetic fields; and
each of the particles has spin current path candidates that connect the south pole region and the north pole region;
and wherein a voltage is applied between the south pole region and the north pole region along the easy direction of magnetization during operation, which causes
(a) an inside of each of the particles to enter a superconducting state;
(b) a spin current to flow through one of the spin current path candidates in a site existing between the south pole region and the north pole region;
(c) an electrical current to flow in a site from an outside to the south pole region of the particle and a site from the outside to the north pole region of the particle; and
(d) electrical current-spin current conversion to occur in the south pole region and the north pole region;
thereby achieving electrical conduction in the thickness direction of the electrically insulative thin film through the conduction portions.

2. The anisotropic electroconductive film according to claim 1, wherein each of the conduction portions is formed by one of the particles; and
a diameter of the particle is set to be larger than a thickness of the electrically insulative thin film so that ends of the particle protrude respectively from both sides of the electrically insulative thin film in a state where the electrically insulative thin film is not deformed by pressure.

3. The anisotropic electroconductive film according to claim 1, wherein each of the conduction portions is formed by a cluster made of the particles that are arranged in the thickness direction of the electrically insulative thin film; and
a length of the cluster in the thickness direction of the electrically insulative thin film is set to be larger than a thickness of the electrically insulative thin film so that ends of the particles are respectively exposed to both sides of the electrically insulative thin film in a state where the electrically insulative thin film is not deformed by pressure.

4. The anisotropic electroconductive film according to claim 1, wherein the electrically insulative thin film is in a form of a sheet that is barely stretched or shrunk in the in-plane direction of the electrically insulative thin film and that is flexible in the thickness direction of the electrically insulative thin film.

5. The anisotropic electroconductive film according to any one of claims 1 to 4, wherein the electrically insulative substance exhibiting topological antiferromagnetic properties that forms the particles is NiO (nickel oxide) or MnO (manganese oxide).

6. The anisotropic electroconductive film according to claim 1, wherein the particle is an approximately spherical particle with a diameter in a range from approximately 0.1 µm to approximately 10 µm, and is formed by aggregated microparticles made of a substance exhibiting topological antiferromagnetic properties;
and the surface of the approximately spherical particle has microprotrusions formed by the microparticles; the microprotrusions forming height differences in a range from approximately 10 nm to approximately 100 nm.

7. The anisotropic electroconductive film according to claim 1, wherein the electrically insulative thin film has a thickness less than twice a median diameter of the particles.

8. The anisotropic electroconductive film according to claim 1, wherein the magnetic anisotropy of the particle is imparted by applying, during a formation process of the electrically insulative thin film, a magnetic field of strength within a range from a critical magnetic field Hc1 at which an applied magnetic field begins to enter the particle to a critical magnetic field Hc2 at which magnetization saturates in a direction of the magnetic field and a direction of the magnetization begins to become disordered.

9. An electroconductive connector for use in a testing apparatus, in which electrical signals are transmitted and received between a test object and the testing apparatus in a state where the electroconductive connector is in contact with terminals of the test object; which comprises:
a first anisotropic electroconductive film formed by the anisotropic electroconductive film according to any one of claims 1 to 8;
a second anisotropic electroconductive film formed by the anisotropic electroconductive film according to any one of claims 1 to 8, the second anisotropic electroconductive film being stacked on the first anisotropic electroconductive film; and
movable electrodes disposed between the first anisotropic electroconductive film and the second anisotropic electroconductive film, the movable electrodes being movable in a stacking direction of the second anisotropic electroconductive film;
wherein the movable electrodes are positioned so as to align to positions of the terminals.

10. The electroconductive connector according to claim 9, wherein each of the movable electrodes is formed by a rigid material having a shape of an approximately circular plate;
the movable electrodes are configured to be movable between the first anisotropic electroconductive film and the second anisotropic electroconductive film without using a retaining layer; and
when a pressure is applied in the stacking direction while the electroconductive connector is sandwiched between the test object and the testing apparatus, each of the movable electrodes is contacted with and electrically connected to one or more of the conduction portions of the first anisotropic electroconductive film corresponding thereto and is contacted with and electrically connected to one or more of the conduction portions of the second anisotropic electroconductive film corresponding thereto.

11. The electroconductive connector according to claim 9 or 10, further comprising:
a third anisotropic electroconductive film stacked on the first anisotropic electroconductive film and the second anisotropic electroconductive film;
wherein the third anisotropic electroconductive film is located on a side of the first anisotropic conductive film or on a side of the second anisotropic conductive film, is further provided; and
the third anisotropic electroconductive film is formed by the anisotropic electroconductive film according to any one of claims 1 to 8.

12. An electroconductive structure that is usable as a conduction portion of an anisotropic electroconductive film, comprising:
at least one approximately spherical particle formed by a substance exhibiting topological antiferromagnetic properties;
wherein the particle has magnetic anisotropy, and has a south pole region and a north pole region that are respectively formed at two ends thereof in a direction along the easy direction of magnetization;
and wherein a voltage is applied between the south pole region and the north pole region,
(a) an inside and an interface of the microparticle enter a topological superconducting state,
(b) a spin current flows in a site existing between the south pole region and the north pole region,
(c) an electrical current flows in a site from an outside to the south pole region of the particle and a site from the outside to the north pole region of the particle, and
(d) electrical current-spin current conversion occurs in the south pole region and the north pole region,
whereby electrical conduction through the particle is achieved.

13. The electroconductive structure according to claim 12, wherein NiO (nickel oxide) or MnO (manganese oxide) is used as the substance exhibiting topological antiferromagnetic properties that forms the particle.

14. The electroconductive structure according to claim 12 or 13, wherein the particle is an approximately spherical particle which is formed by aggregated microparticles made of the substance exhibiting topological antiferromagnetic properties;
the particle has a diameter in a range from approximately 0.1 µm to approximately 10 µm, and
the surface of the particle has microprotrusions formed by the microparticles, the microparticles forming height differences in a range from approximately 10 nm to approximately 100 nm.

15. The electroconductive structure according to claim 14, wherein the magnetic anisotropy of the particle is imparted by applying, during a formation process of the electrically insulative thin film, a magnetic field of strength within a range from a critical magnetic field Hc1 at which an applied magnetic field begins to enter the particle to a critical magnetic field Hc2 at which magnetization saturates in a direction of the magnetic field and a direction of the magnetization begins to become disordered.
